# EUROPEAN PATENT APPLICATION

(11) **EP 2 501 209 A1**
(43) Date of publication of application: **19.09.2012**
(21) Application number: 12159201.8
(22) Date of filing: 13.03.2012
(51) Int. Cl.: H05K 3/42, H05K 1/11, H05K 3/00

(54) **Printed wiring board, printed circuit board unit, electronic apparatus and method for manufacturing printed wiring board**

(30) Priority: 15.03.2011 JP 2011057272
(71) Applicant: Fujitsu Limited, Kawasaki-shi, Kanagawa 211-8588 (JP)
(72) Inventor: Nakamura, Naoki, Kanagawa, 211-8588 (JP); Sugane, Mitsuhiko, Kanagawa, 211-8588 (JP); Matsui, Akiko, Kanagawa, 211-8588 (JP); Yamada, Tetsuro, Kanagawa, 211-8588 (JP); Mukoyama, Takahide, Kanagawa, 211-8588 (JP); Hiroshima, Yoshiyuki, Kanagawa, 211-8588 (JP); Ooi, Takahiro, Kanagawa, 211-8588 (JP)
(74) Representative: HOFFMANN EITLE

(57) **Abstract**

A printed wiring board is disclosed that includes insulating layers (11,12,13,14,15), conductive layers (21,22,23,24,25) stacked with the insulating layers alternately, a through hole (60) penetrating the insulating layers and the conductive layers, a first plate resist part (50) formed on a first portion of an inner wall of the through hole, the first portion being located from one end of the through hole to one of the conductive layers stacked between one pair of the insulating layers, and a plated part (40) formed on a second portion of the inner wall of the through hole other than the first portion.

## Description

### FIELD

The embodiments discussed herein are related to a printed wiring board, a printed circuit board unit, an electronic apparatus and a method for manufacturing a printed wiring board.

### BACKGROUND

Conventionally, there have been methods for forming vias that are connected to inner lines of printed wiring boards. According to one of the methods, a metal film is formed onto an inner wall of a through hole and is connected to the inner line of the printed wiring board. Then, an unnecessary portion of the metal film which branches from the inner line and forms a stub is removed from a back side of the printed wiring board, because the stub causes reflection and/or noise of a signal which is transmitted on the inner line.

Further, according to another method, a plate resist is formed into a gap which is formed by removing a portion of an inner conductive layer of a printed wiring board, and a through hole which penetrates through the plate resist is formed. And then, plate is formed on an inner wall of the through hole so that two vias that are divided by the plate resist and located on the upside and downside of the plate resist are formed.

However, according to the method in which the unnecessary portion of the metal film is removed from the back side of the printed wiring board (hereinafter referred to as "back drilling method"), it is difficult to remove the stub completely, because of reasons such as machining accuracy or the like, for example. Accordingly, the back drilling method may cause a problem in that a remaining portion of the unnecessary portion may still reflect the signal or may still generate noise.

Further, according to the back drilling method, the via may be damaged. Cutting scraps made by a drilling process may remain in the through hole. Since the back drilling method is performed by a machining process, the diameter of the through hole on the back side of the printed wiring board may be increased and the inner lines may experience an unexpected effect.

On the contrary, according to the method in which the two vias that are located on the upside and downside of the plate resist are formed, the plate resist is formed into a space which is formed by removing a portion of a single conductive layer or a space which is formed by removing a portion of a single insulating layer and corresponding portions of two conductive layers formed one on each surface of the insulating layer. Thus, a stub may remain on upside and downside of an inner wall of the plate resist. If the stub remains, reflection of signals transmitted through the conductive layers or noise of the signals may occur.

Further, the thickness of the plate resist which is formed into the space that is formed by removing the single conductive layer may not be enough for insulating the two vias. Thus, the two vias may contact each other over the plate resist.

If problems as described above occur, transmission characteristics of the signals transmitted through the printed wiring board may fall off, particularly transmission characteristics of high-speed signals may fall off greatly.

### [PRIOR ART REFERENCES]

### [PATENT REFERENCES]

[Patent Reference 1] United States Patent No. 6,663,442
[Patent Reference 2] Japanese Patent Laid-Open Publication No. 2008-532326

### SUMMARY

Accordingly, it is an object in one aspect of the invention to provide a printed wiring board, a printed circuit board unit, an electronic apparatus and a method for manufacturing the printed wiring board that have enhanced transmission characteristics of high speed signals.

According to an aspect of an embodiment, there is provided a printed wiring board including insulating layers; conductive layers stacked with the insulating layers alternately; a through hole penetrating the insulating layers and the conductive layers; a first plate resist part formed on a first portion of an inner wall of the through hole, the first portion being located from one end of the through hole to one of the conductive layers stacked between one pair of the insulating layers; and a plated part formed on a second portion of the inner wall of the through hole other than the first portion.

In another aspect, there is provided a printed wiring board including insulating layers including a prepreg layer; conductive layers stacked with the insulating layers alternately; a through hole penetrating the insulating layers and the conductive layers; a plate resist part formed on a first portion of an inner wall of the through hole, the first portion being formed in the prepreg layer and located between a pair of the conductive layers; and a plated part formed on a second portion of the inner wall of the through hole other than the first portion of the inner wall of the through hole.

In another aspect, there is provided a method for manufacturing a printed wiring board, the method including stacking conductive layers and insulating layers alternately; forming a through hole penetrating the conductive layers and insulating layers; forming a plate resist part on a first portion of an inner wall of the through hole, the first portion being located from one end of the through hole to one of the conductive layers stacked between one pair of the insulating layers; and forming a plated part on a second portion of the inner wall of the through hole other than the first portion.

In another aspect, there is provided a method for manufacturing a printed wiring board, the method including forming a first through hole in a prepreg layer; suppying a plate resist in the first through hole; stacking conductive layers and insulating layers alternately, the insulating layers including the prepreg layer; forming a second through hole penetrating the stacked conductive layers and insulating layers, the second through hole penetrating the plate resist; and forming a plated part on a portion of an inner wall of the second through hole other than the plate resist.

### BRIEF DESCRIPTION OF THE DRAWINGS

FIG. 1 is a diagram illustrating a server including a printed wiring board of a first embodiment;
FIG. 2 is a diagram illustrating the printed circuit board unit in which a CPU or the like is mounted on the printed wiring board;
FIG. 3 is a diagram illustrating a cross section of the printed wiring board of the first embodiment;
FIG. 4A is a diagram illustrating a cross section of the printed wiring board of the first embodiment during a manufacturing process;
FIG. 4B is a diagram illustrating the cross section of the printed wiring board of the first embodiment during the manufacturing process;
FIG. 5A is a diagram illustrating the cross section of the printed wiring board of the first embodiment during the manufacturing process;
FIG. 5B is a diagram illustrating the cross section of the printed wiring board of the first embodiment during the manufacturing process;
FIG. 5C is a diagram illustrating the cross section of the printed wiring board of the first embodiment during the manufacturing process;
FIG. 6 is a diagram illustrating a cross section of a printed wiring board of a second embodiment;
FIG. 7A is a diagram illustrating a cross section of the printed wiring board of the second embodiment during a manufacturing process;
FIG. 7B is a diagram illustrating the cross section of the printed wiring board of the second embodiment during the manufacturing process;
FIG. 7C is a diagram illustrating the cross section of the printed wiring board of the second embodiment during the manufacturing process;
FIG. 8 is a diagram illustrating a cross section of a printed wiring board of an exemplary variation of the second embodiment;
FIG. 9A is a diagram illustrating the cross section of the printed wiring board of the exemplary variation of the second embodiment during a manufacturing process;
FIG. 9B is a diagram illustrating the cross section of the printed wiring board of the exemplary variation of the second embodiment during the manufacturing process;
FIG. 10 is a diagram illustrating a cross section of a printed wiring board of a third embodiment;
FIG. 11A is a diagram illustrating a cross section of the printed wiring board of the third embodiment during a manufacturing process;
FIG. 11B is a diagram illustrating the cross section of the printed wiring board of the third embodiment during the manufacturing process;
FIG. 12A is a diagram illustrating the cross section of the printed wiring board of the third embodiment during the manufacturing process;
FIG. 12B is a diagram illustrating the cross section of the printed wiring board of the third embodiment during the manufacturing process;
FIG. 13 is a diagram illustrating a cross section of a printed wiring board of a fourth embodiment;
FIG. 14A is a diagram illustrating a cross section of the printed wiring board of the fourth embodiment during a manufacturing process;
FIG. 14B is a diagram illustrating a cross section of the printed wiring board of the fourth embodiment during the manufacturing process;
FIG. 15A is a diagram illustrating a cross section of the printed wiring board of the fourth embodiment during the manufacturing process;
FIG. 15B is a diagram illustrating a cross section of the printed wiring board of the fourth embodiment during the manufacturing process;
FIG. 15C is a diagram illustrating a cross section of the printed wiring board of the fourth embodiment during the manufacturing process;
FIG. 16 is a diagram illustrating a cross section of a printed wiring board of the fifth embodiment;
FIG. 17A is a diagram illustrating a cross section of the printed wiring board of the fifth embodiment during a manufacturing process;
FIG. 17B is a diagram illustrating the cross section of the printed wiring board of the fifth embodiment during the manufacturing process;
FIG. 18A is a diagram illustrating the cross section of the printed wiring board of the fifth embodiment during the manufacturing process;
FIG. 18B is a diagram illustrating the cross section of the printed wiring board of the fifth embodiment during the manufacturing process;
FIG. 19A is a diagram illustrating the cross section of the printed wiring board of the fifth embodiment during the manufacturing process; and
FIG. 19B is a diagram illustrating the cross section of the printed wiring board of the fifth embodiment during the manufacturing process.

### DESCRIPTION OF EMBODIMENTS

A description is given, with reference to the accompanying drawings, of embodiments of a printed wiring board, a printed circuit board unit, an electronic apparatus and a method for manufacturing the printed wiring board.

### <FIRST EMBODIMENT>

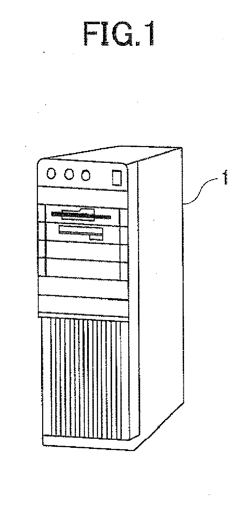

FIG. 1 is a diagram illustrating a server 1 including a printed wiring board of the first embodiment.

The server 1 as illustrated in FIG. 1 is one example of an electronic apparatus including the printed wiring board of the first embodiment. The server 1 includes a Central Processing Unit (CPU) and a memory module or the like that are mounted on the printed wiring board of the first embodiment, for example. Although, the server 1 is illustrated as one example of the electronic apparatus of the first embodiment, the electronic apparatus may be a Personal Computer (PC).

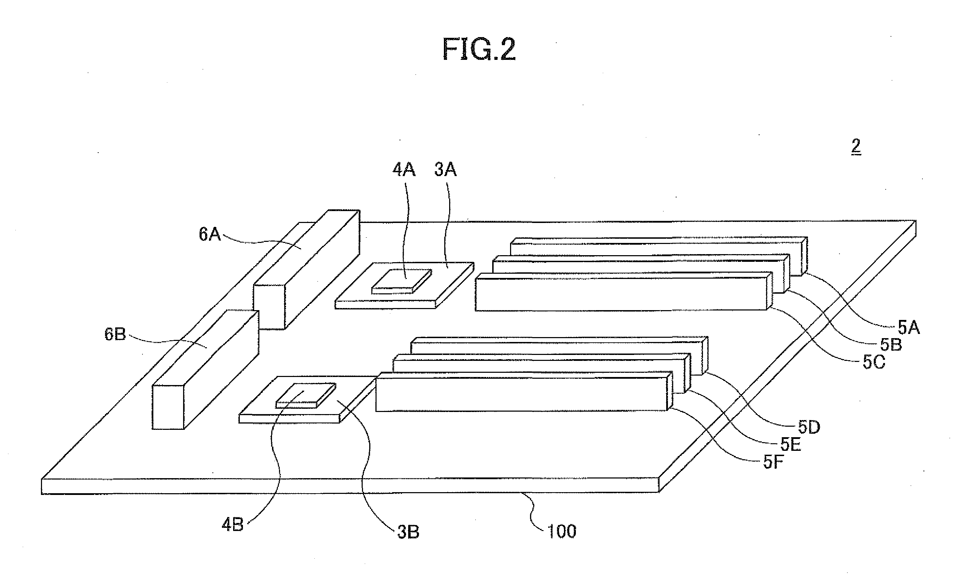

FIG. 2 is a diagram illustrating a printed circuit board unit 2 in which a CPU or the like is mounted on a printed wiring board 100.

The printed circuit board unit 2 includes the printed wiring board 100, Ball Grid Arrays (BGA) 3A and 3B, CPUs 4A and 4B, memory modules 5A to 5F and power modules 6A and 6B. The BGAs 3A and 3B, the CPUs 4A and 4B, the memory modules 5A to 5F and the power modules 6A and 6B are examples of the electronic devices.

The BGAs 3A and 3B, the memory modules 5A to 5F and the power modules 6A and 6B are mounted on the printed wiring board 100, and the CPUs 4A and 4B are mounted on the BGAs 3A and 3B, respectively.

The printed circuit board unit 2 as described above is included in the server 1 as illustrated in FIG. 1.

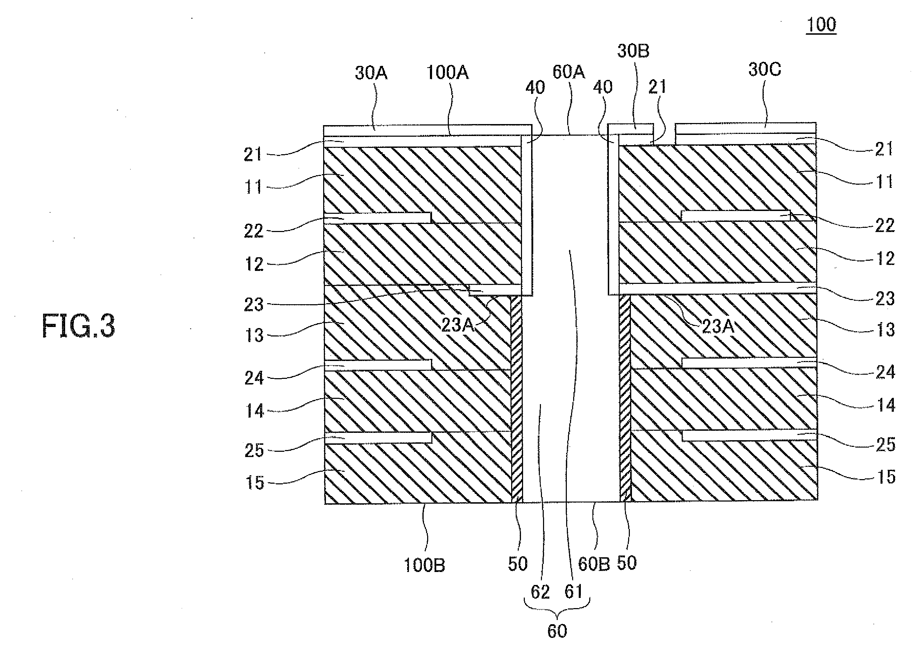

FIG. 3 is a diagram illustrating a cross section of the printed wiring board 100 of the first embodiment.

The printed wiring board 100 includes five insulating layers 11, 12, 13, 14 and 15, five conductive layers 21, 22, 23, 24 and 25, plated layers 30A, 30B and 30C, a via 40 and a plate resist part 50. A through hole 60 is formed in the printed wiring board 100. The through hole 60 penetrates the printed wiring board 100 from the top surface 100A to the bottom surface 100B. The via 40 and the plate resist part 50 are formed on the inner wall of the through hole 60, and are formed in cylindrical shapes along the inner wall, respectively.

The through hole 60 includes a hole 61 in which the via 40 is formed and a hole 62 in which the plate resist part 50 is formed. The inner diameters of the holes 61 and 62 are different. The inner diameter of the hole 62 is larger than that of the hole 61.

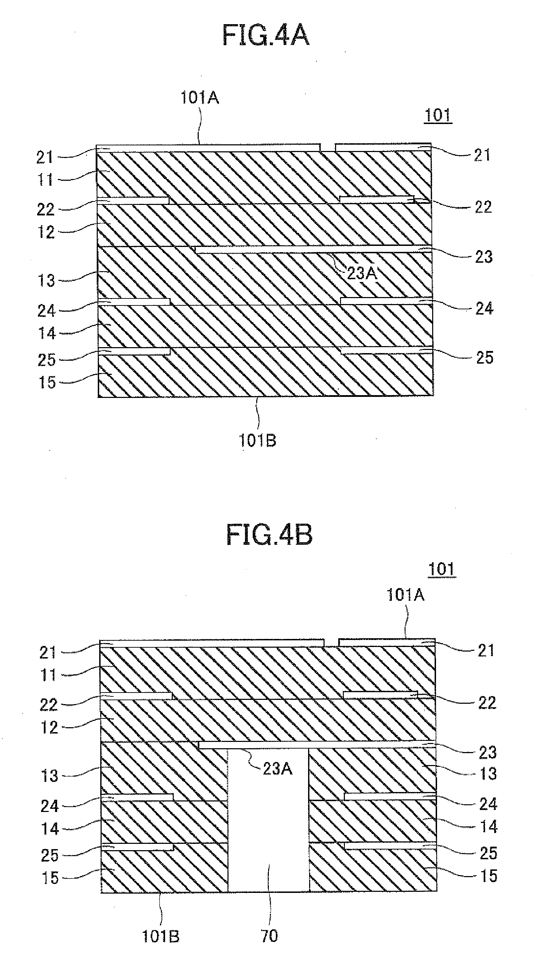

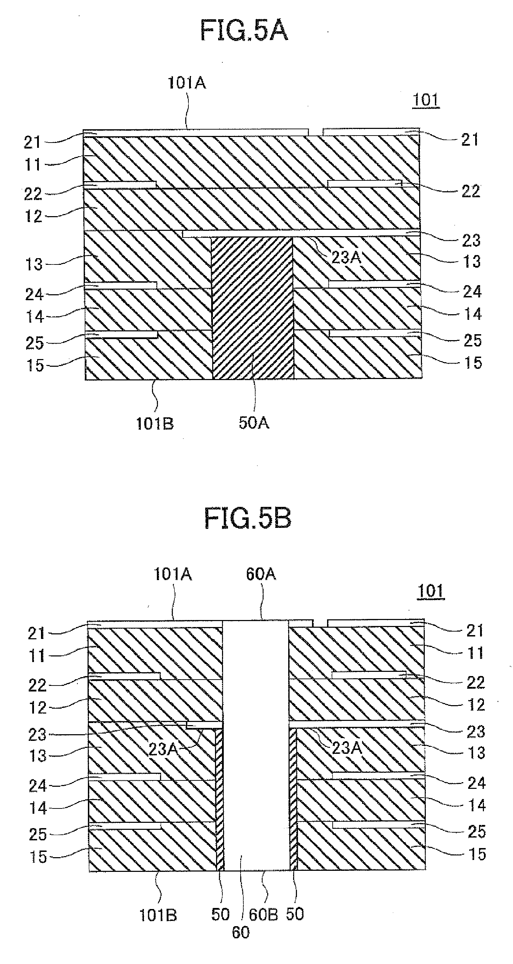

Herein, the inner diameter of the hole 61 does not include the thickness of the via 40 (see FIG. 5B), and the inner diameter of the hole 62 does not include the thickness of the plate resist part 50 (see FIG. 4B). The inner diameter of the hole 62 is equal to that of a hole 70 which will be described later.

The printed wiring board 100 is a type of a printed wiring board which is made of Flame Retardant type 4 (FR-4) or FR-5 glass epoxy, for example. The glass epoxy is made of a fiberglass cloth and an epoxy resin.

The insulating layers 11, 13 and 15 may be layers that are made by impregnating thermosetting resin into fibers, and may more specifically be prepreg layers that are made by impregnating epoxy resin with fiberglass cloth fibers, for example. The insulating layers 12 and 14 may be core layers, for example. However, the prepreg layers may be a type of layer that is made of epoxy resin and does not include fibers.

The conductive layers 21, 22, 23, 24 and 25 may be made of copper foil, for example. The conductive layers 21, 22, 23, 24 and 25 may be used as a signal layer, a power layer, a ground layer or the like, for example.

In a portion of the printed wiring board 100 as illustrated in FIG. 3, patterns of the conductive layers 21, 22, 23, 24 and 25 in plan view are determined by whether the conductive layers 21, 22, 23, 24 and 25 are connected to the via 40 or not.

For example, the conductive layers 22, 24 and 25 that are not connected to the via 40 have circular openings, respectively, that are larger than the through hole 60 in plan view, in order to keep away from the through hole 60. The through hole 60 and the conductive layers 22, 24 and 25 are designed and disposed in the printed wiring board 100 so that they are aligned in a concentric fashion in plan view. Although the conductive layers 21, 22, 24 and 25 are divided in two pieces in FIG. 3, the two pieces of the respective conductive layers 21, 22, 24 and 25 are connected with each other in reality.

The insulating layers 11, 12, 13, 14 and 15 and the conductive layers 21, 22, 23, 24 and 25 are adhered to each other by a thermosetting process which is treated in a situation where the conductive layers 22 and 23 and the conductive layers 24 and 25 are formed on opposing surfaces of the insulating layers 12 and 14, respectively, that constitute the core layers.

Herein, a cross section of a portion of the printed wiring board 100 is illustrated as a matter of practical convenience. A conductive layer may be formed on the bottom surface 100B of the printed wiring board 100 in a portion that is not illustrated in FIG. 3. The printed wiring board 100 may include plural of the through holes 60.

Although the top surface of the conductive layer 21 is illustrated as the top surface 100A of the printed wiring board 100 in FIG. 3, the top surface of the insulating layer 11 becomes the top surface 100A of the printed wiring board 100 in a portion where the conductive layer 21 is not formed on the insulating layer 11.

Similarly, although the bottom surface of the insulating layer 15 is illustrated as the bottom surface 100B of the printed wiring board 100, a bottom surface of a conductive layer becomes the bottom surface 100B of the printed wiring board 100 in a portion where the conductive layer is formed on the bottom surface of the insulating layer 15.

The printed wiring board 100 may not be limited to the printed wiring board made of FR-4 or FR-5 glass epoxy. The printed wiring board 100 may be a printed wiring board which is made of another type of FR series, or may be a printed wiring board other than FR series, as long as the printed wiring board includes an inner conductive layer.

The through hole 60 is formed in the printed wiring board 100. The through hole 60 penetrates the printed wiring board 100 from the top surface 100A to the bottom surface 100B. The through hole 60 is formed in order to form the via 40 which connects the conductive layers 21 and 23.

At first, the plate resist part 50 is formed on the inner wall of the through hole 60 from the bottom surface 100B of the printed wiring board 100 (the bottom edge 60B of the through hole 60) to the bottom surface 23A of the conductive layer 23. Next, a non-electrolytic plated layer is formed on the inner wall of the through hole 60, and then an electrolytic plated layer is formed on the non-electrolytic layer. Accordingly, the via 40 is formed on the inner wall of the through hole 60 on which the plate resist part 50 is not formed.

As described above, in the through hole 60, the inner diameter of the hole 62 in which the plate resist part 50 is formed is larger than that of the hole 61 in which the via 40 is formed. A method for forming the through hole 60 will be described later.

The via 40 is one example of a cylindrical plated part which is formed on the inner wall of the through hole 60 by the non-electrolytic layer and the electrolytic layer. The via 40 is formed in a portion of the through hole 60 in which the plate resist part 50 is not formed. The portion in which the via 40 is formed is located from the top edge 60A of the through hole 60 to a portion which is located on the same level as the bottom surface 23A of the conductive layer 23.

Accordingly, the top edge of the via 40 is connected to the conductive layer 21, and the bottom edge of the via 40 is connected to the conductive layer 23. Thus, the conductive layer 21 which constitutes the top layer of the printed wiring board 100 and the conductive layer 23 which constitutes one of the inner layers of the printed wiring board 100 are connected by the via 40.

When the via 40 is formed on the inner wall of the through hole 60, the plated layers 30A, 30B and 30C are formed on the conductive layer 21 in the same plating process as the plating process for forming the via 40. The plated layers 30A, 30B and 30C are patterned in a peripheral area of the top edge 60A of the through hole 60 in accordance with the pattern of the conductive layer 21 by using masks, resists or the like that are not illustrated in FIG. 3.

In FIG. 3, the plated layers 30A and 30B are connected to the via 40 and are connected to each other around the through hole 60 in plan view. The plated layer 30C is not connected to the plated layers 30A and 30B and the via 40.

Although the via 40 and the plated layers 30A and 30B are described above as a matter of practical convenience, the via 40 and the plated layers 30A and 30B are formed integrally. Hereinafter, the plated layers 30A, 30B and 30C may be referred to as a plated layer 30 in a case where the plated layers 30A, 30B and 30C are not distinguished.

The non-electrolytic plated layer and the electrolytic plated layer that constitute the via 40 and the plated layer 30 may be made of copper plate, for example. However, the via 40 and the plated layer 30 may not be limited to the copper plates, the via 40 and the plated layer 30 may be made of plates other than the copper plates. The via 40 and the plated layer 30 may be made of nickel plates, tin plates, zinc plates or the like, for example.

The plate resist part 50 is one example of a cylindrical plate resist part which is formed on the inner wall of the through hole 60 from the bottom surface 100B of the printed circuit 100 (the bottom edge 60B of the through hole 60) to the bottom surface 23A of the conductive layer 23.

Herein, forming the plate resist part 50 from the bottom surface 100B of the printed wiring board 100 (the bottom edge 60B of the through hole 60) to the bottom surface 23A of the conductive layer 23 means forming the plate resist part 50 from the bottom edge 60B of the through hole 60 to a portion at which the plate resist part 50 contacts the bottom surface 23A of the conductive layer 23.

A fluorine resin, a silicon resin or an olefin resin having poor non-electrolytic plate adhesion may be used as the plate resist part 50, for example.

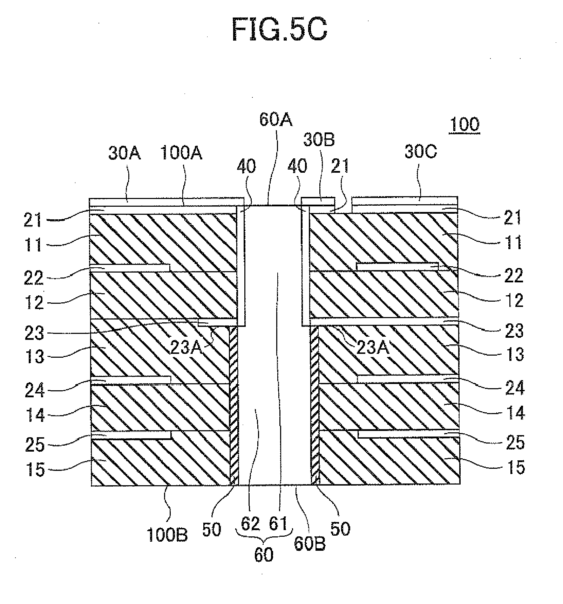

Next, the method for manufacturing the printed wiring board 100 of the first embodiment is described with reference to FIGS. 4A, 4B, 5A, 5B and 5C. Herein, a printed wiring board 101 is a printed wiring board during the manufacturing process, i.e. a printed wiring board before the completion of the printed wiring board 100.

FIGS. 4A, 4B, 5A, 5B and 5C are diagrams illustrating cross sections of the printed wiring board 101 of the first embodiment during the manufacturing process. In FIGS. 4 and 5, the size of the printed wiring board 101 is reduced compared with the printed wiring board 100 as illustrated in FIG. 3.

At first, as illustrated in FIG. 4A, the insulating layers 11, 12, 13, 14 and 15 and the conductive layers 21, 22, 23, 24 and 25 are stacked and interleaved with each other and adhered to each other by the thermosetting process, in order to form the printed wiring board 101.

Next, as illustrated in FIG. 4B, a hole 70 is formed by a laser beam machining or the like that is performed from the bottom surface 101B of the printed wiring board 101. The laser machining is performed until the hole 70 reaches the bottom surface 23A of the conductive layer 23. In this process, portions of the insulating layers 13, 14 and 15 are removed as illustrated in FIG. 4B.

For example, it is possible to stop the laser machining at the bottom surface 23A of the conductive layer 23 by setting laser power of a CO₂ laser to a designated value which is optimized for removing the portions of the insulating layers 13, 14 and 15.

Herein, it is necessary to apply more laser power for removing the conductive layer 23 than for removing the insulating layers 13, 14 and 15. Accordingly, the laser power of the laser machining may be set to a value which is enough for removing the insulating layers 13, 14 and 15 and is less than the laser power that is necessary for removing the conductive layer 23.

Thus, it is possible to form the hole 70 which reaches the bottom surface 23A of the conductive layer 23 from the bottom surface 101B of the printed wiring board 101.

The hole 70 is formed at a position to which the through hole 60 is to be formed later, so that the hole 70 and the through hole 60 are aligned in a concentric fashion in plan view.

The inner diameter of the hole 70 may be set to a value which is larger than the inner diameter of the through hole 60 by the thickness of the plate resist part 50, in view of forming the plate resist part 50 later.

Next, as illustrated in FIG. 5A, a plate resist part 50A is formed by supplying a plate resist into the hole 70 (see FIG. 4B). The plate resist part 50A is formed from the bottom surface 23A of the conductive layer 23 to the bottom surface 101B of the printed wiring board 101.

A fluorine resin, silicon resin or olefin resin having poor non-electrolytic plate adhesion may be used as the plate resist, for example.

Next, as illustrated in FIG. 5B, the through hole 60 which penetrates the printed wiring board 101 from the top surface 101A to the bottom surface 101B is formed by drilling the printed wiring board 101 from the top surface 101A or the bottom surface 101B.

At this stage, the plate resist part 50 is formed on the inner wall of the through hole 60 from the bottom surface 101B of the printed wiring board 101 (the bottom edge 60B of the through hole 60) to the bottom surface 23A of the conductive layer 23.

Next, as illustrated in FIG. 5C, the via 40 and the plated layers 30A, 30B and 30C are formed by forming the non-electrolytic plated layer and by forming the electrolytic plated layer on the non-electrolytic plated layer. Herein, the non-electrolytic plated layer is formed by impregnating the printed wiring board 101 with a non-electrolytic plate liquid solution.

Since the plate resist part 50 is formed on the inner wall of the through hole 60 from the bottom edge 60B of the through hole 60 to the bottom surface 23A of the conductive layer 23, the via 40 is not formed in a portion of the through hole 60 where the plate resist part 50 is formed.

The via 40 is formed on a portion of the inner wall of the through hole 60 where the plate resist part 50 is not formed. Accordingly, the via 40 is formed on the inner wall of the hole 61 which is located between the bottom surface 23A and the top edge 60A.

Accordingly, the bottom edge of the via 40 is connected to the conductive layer 23 which constitutes one of the inner layers, and the top edge of the via 40 is connected to the conductive layer 21 and the plated layer 30.

According to the processes as described above, the printed wiring board 100 as illustrated in FIG. 5C is completed. The printed wiring board 100 as illustrated in FIG. 5C is equal to the printed wiring board 100 as illustrated in FIG. 3.

The via 40 of the printed wiring board 100 is different from the via formed by the conventional method in that it becomes possible to suppress formation of the stub at the point where the via 40 is connected to the conductive layer 23 which constitutes one of the inner layers.

According to the first embodiment, it becomes possible to suppress formation of the via 40 in the portion of the through hole 60 lower than the bottom surface 23A of the conductive layer 23 by forming the plate resist part 50 from the bottom surface 100B of the printed circuit 100 (the bottom edge 60B of the through hole 60) to the bottom surface 23A of the conductive layer 23 with high dimensional accuracy. Thus, the formation of the stub at the point where the via 40 is connected to the conductive layer 23 is suppressed.

Therefore, according to the first embodiment, it becomes possible to provide the printed wiring board 100 which can suppress occurrence of reflection of a signal, noise or the like and which has enhanced transmission characteristics of high speed signals by suppressing the formation of the stub.

Since the machining process such as the back drilling method is not performed, the via 40 is not damaged during the manufacturing process and cutting scraps or the like do not remain in the through hole 60. Further, the diameter of the portion of the through hole 60 between the bottom edge 60B and the bottom surface 23A (the portion of the through hole 60 in which the via 40 is not formed) is not increased and the conductive layers 21 to 25 do not experience unexpected effects during the manufacturing process.

Thus, according to the first embodiment, it becomes possible to provide the printed wiring board 100 which has highly-enhanced transmission characteristics of the high speed signals compared with the conventional printed wiring board manufactured by the conventional method.

### <SECOND EMBODIMENT>

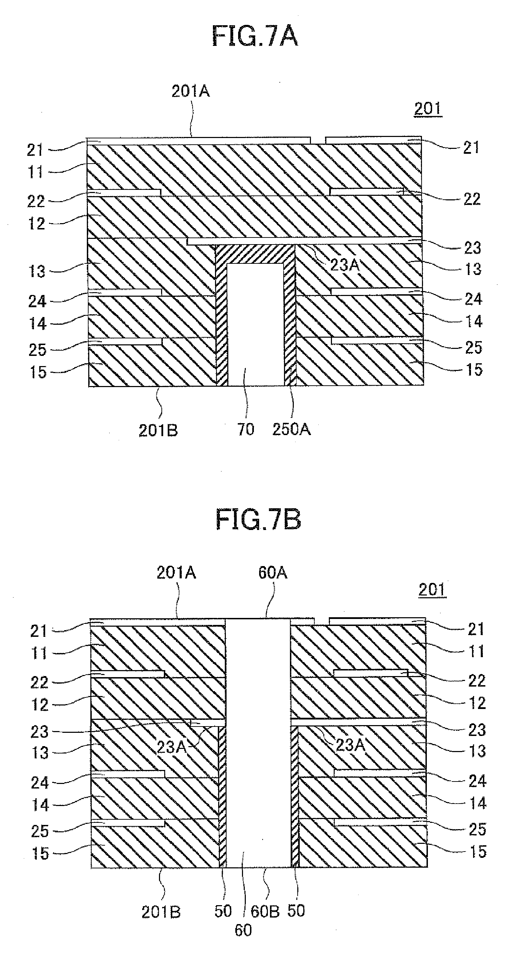

According to a printed wiring board 200 of the second embodiment, a method for forming a plate resist part 250A (see FIG. 7A) is different from that of the plate resist part 50A of the printed wiring board 100 of the first embodiment. Otherwise, the printed wiring board 200 according to the second embodiment is the same as the printed wiring board 100 of the first embodiment. Accordingly, the same elements as or elements similar to those of the printed wiring board 100 of the first embodiment are referred to by the same reference numerals, and a description thereof is omitted. Further, figures of the first embodiment may be incorporated herein.

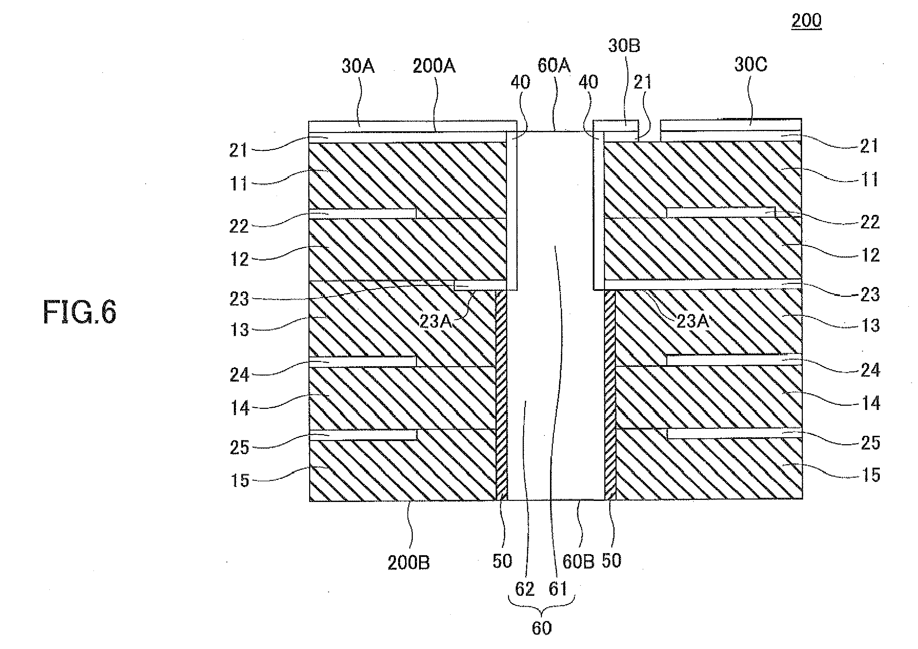

FIG. 6 is a diagram illustrating a cross section of the printed wiring board 200 of the second embodiment.

The printed wiring board 200 includes five insulating layers 11, 12, 13, 14 and 15, five conductive layers 21, 22, 23, 24 and 25, plated layers 30A, 30B and 30C, a via 40 and a plate resist part 50. A through hole 60 is formed in the printed wiring board 200. The through hole 60 penetrates the printed wiring board 200 from the top surface 200A to the bottom surface 200B. The via 40 and the plate resist part 50 are formed on the inner wall of the through hole 60, and are formed in cylindrical shapes along the inner wall, respectively.

As described above, the printed wiring board 200 according to the second embodiment has similar configuration to the printed wiring board 100 of the first embodiment (see FIG. 3).

Although the top surface of the conductive layer 21 is illustrated as the top surface 200A of the printed wiring board 200 in FIG. 6, the top surface of the insulating layer 11 becomes the top surface 200A of the printed wiring board 200 in a portion where the conductive layer 21 is not formed on the insulating layer 11.

Similarly, although the bottom surface of the insulating layer 15 is illustrated as the bottom surface 200B of the printed wiring board 200, a bottom surface of a conductive layer becomes the bottom surface 200B of the printed wiring board 200 in a portion where the conductive layer is formed on the bottom surface of the insulating layer 15.

Next, the method for manufacturing the printed wiring board 200 of the second embodiment is described. The method for manufacturing the printed wiring board 200 of the second embodiment includes similar processes to the processes as illustrated in FIGS. 4A and 4B of the first embodiment. Further the method includes a process as illustrated in FIG. 7A instead of the process as illustrated in FIG. 5A of the first embodiment.

Accordingly, the method for manufacturing the printed wiring board 200 (201) of the second embodiment is described assuming that similar processes to the processes as described with reference to FIGS 4A and 4B are performed on the printed wiring board 200 (201).

Herein, the printed wiring board 201 is a printed wiring board during the manufacturing process, i.e. a printed wiring board before the completion of the printed wiring board 200.

FIGS. 7A to 7C are diagrams illustrating cross sections of the printed wiring board 201 of the second embodiment during manufacturing processes, respectively. In FIGS. 7A to 7C, the size of the printed wiring board 201 is reduced compared with the printed wiring board 200 as illustrated in FIG. 6.

As illustrated in FIG. 7A, the plate resist part 250A is formed in the hole 70 after the hole 70 (see FIG. 4B) is formed from the bottom surface 201B of the printed wiring board 201 by laser beam machining or the like.

In order to form the plate resist part 250A, a brush, a sponge or the like to which a fluorine resin, silicon resin or olefin resin having poor non-electrolytic plate adhesion is applied may be prepared, for example. Then the brush or the like may be inserted into the hole 70 from the bottom edge 70B, and rotated so that the fluorine resin, etc., may be applied on the inner wall of the hole 70. The plate resist part 250A may be formed by the processes as described above, for example.

In these processes, the plate resist part 250A may be formed on the inner wall of the hole 70 by moving the brush, etc., from the bottom edge 70B to the bottom surface 23A of the conductive layer 23 while rotating the brush, etc.

In this case, a drive mechanism of a drill which is used for forming the through hole 60 (see FIG. 6) may be used as a drive mechanism which rotates the brush etc., for example. Further, the drive mechanism of the drill may be used as a drive mechanism which moves the brush, etc., in a direction of the depth of the hole 70.

It becomes possible to form the plate resist part 250A from the bottom edge 70B of the hole 70 to the bottom surface 23A of the conductive layer 23 by using the drive mechanism of the drill as described above, for example.

Herein, the fluorine resin, the silicon resin or the olefin resin may be applied to the brush, the sponge or the like in a state where the fluorine resin, etc., is dissolved in a solvent, for example.

Next, as illustrated in FIG. 7B, the through hole 60 which penetrates the printed wiring board 201 from the top surface 201A to the bottom surface 201B is formed by drilling the printed wiring board 201 from the top surface 201A or the bottom surface 201B.

At this point, the central portion of the plate resist part 250A (see FIG. 7A) is penetrated, and then the plate resist part 50 is formed on the inner wall of the through hole 60 from the bottom surface 201B of the printed wiring board 201 (the bottom edge 60B of the through hole 60) to the bottom surface 23A of the conductive layer 23.

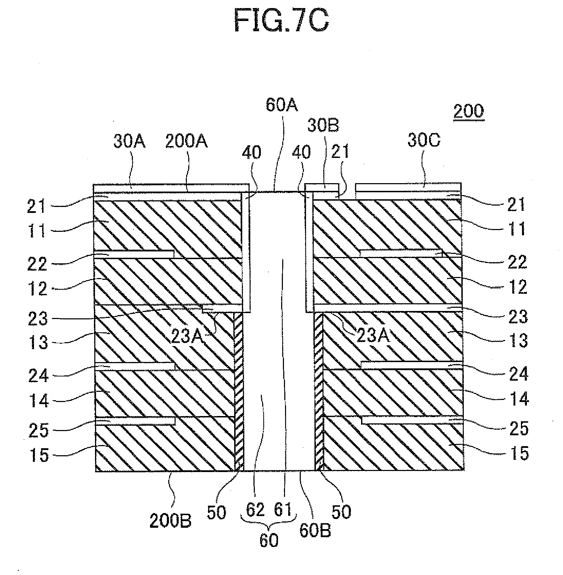

Next, as illustrated in FIG. 7C, the via 40 and the plated layers 30A, 30B and 30C are formed by forming the non-electrolytic plated layer and by forming the electrolytic plated layer on the non-electrolytic plated layer. Herein, the non-electrolytic plated layer is formed by impregnating the printed wiring board 201 with a non-electrolytic plate liquid solution.

Since the plate resist part 50 is formed on the inner wall of the through hole 60 from the bottom edge 60B of the through hole 60 to the bottom surface 23A of the conductive layer 23, the via 40 is not formed in a portion of the through hole 60 where the plate resist part 50 is formed.

The via 40 is formed on a portion of the inner wall of the through hole 60 where the plate resist part 50 is not formed. Accordingly, the via 40 is formed on the inner wall of the hole 61 which is located between the bottom surface 23A and the top edge 60A.

Accordingly, the bottom edge of the via 40 is connected to the conductive layer 23 which constitutes one of the inner layers, and the top edge of the via 40 is connected to the conductive layer 21 and the plated layer 30.

According to the processes as described above, the printed wiring board 200 as illustrated in FIG. 7C is completed. The printed wiring board 200 as illustrated in FIG. 7C is equal to the printed wiring board 200 as illustrated in FIG. 6 and the printed wiring board 100 as illustrated in FIG. 3.

The via 40 of the printed wiring board 200 is different from the via formed by the conventional method in that it becomes possible to suppress formation of the stub at the point where the via 40 is connected to the conductive layer 23 which constitutes one of the inner layers.

According to the first embodiment, it becomes possible to suppress formation of the via 40 in the portion of the through hole 60 lower than the bottom surface 23A of the conductive layer 23 by forming the plate resist part 50 from the bottom surface 200B of the printed circuit 200 (the bottom edge 60B of the through hole 60) to the bottom surface 23A of the conductive layer 23 with high dimensional accuracy. Thus, the formation of the stub at the point where the via 40 is connected to the conductive layer 23 is suppressed.

Therefore, according to the second embodiment, it becomes possible to provide the printed wiring board 200 which can suppress occurrence of reflection of a signal, noise or the like and which has enhanced transmission characteristics of high speed signals by suppressing the formation of the stub.

Since the machining process such as the back drilling method is not performed, the via 40 is not damaged during the manufacturing process and cutting scraps or the like do not remain in the through hole 60. Further, the diameter of the portion of the through hole 60 between the bottom edge 60B and the bottom surface 23A (the portion of the through hole 60 in which the via 40 is not formed) is not increased and the conductive layers 21 to 25 do not experience unexpected effects during the manufacturing process.

Thus, according to the second embodiment, it becomes possible to provide the printed wiring board 200 which has highly-enhanced transmission characteristics of the high speed signals compared with the conventional printed wiring board manufactured by the conventional method.

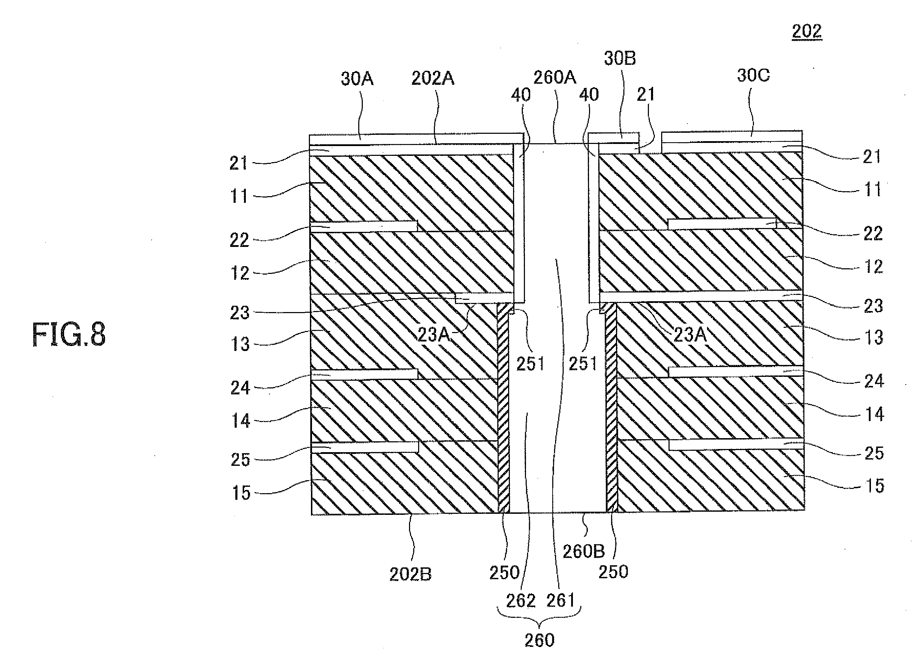

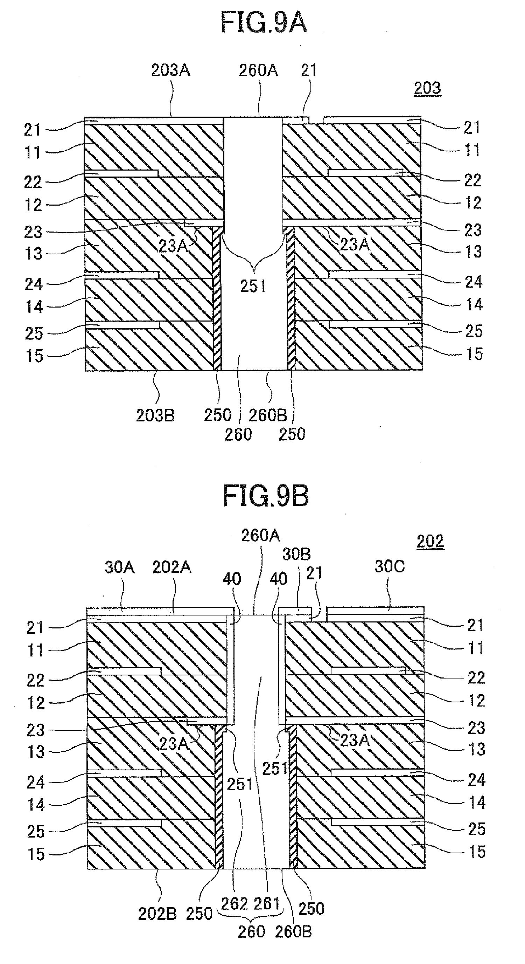

Next, a method for manufacturing a printed wiring board 202 of an exemplary variation of the second embodiment is described with reference to FIGS. 8 and 9.

FIG. 8 is a diagram illustrating a cross section of a printed wiring board 202 of an exemplary variation of the second embodiment.

In the printed wiring board 202, an inner diameter of a hole 261 of a through hole 260 is made smaller than that of the hole 61 (see FIG. 6), and a shape of a plate resist part 250 is different from that of the plate resist part 50 of the printed wiring board 200 (see FIG. 6). The plate resist part 250 includes a convex portion 251 which is formed under the bottom surface 23A of the conductive layer 23. Otherwise, the printed wiring board 202 of the exemplary variation of the second embodiment is the same as the printed wiring board 200 of the second embodiment (see FIG. 6).

Next, the method for manufacturing the printed wiring board 202 (203) of the exemplary variation of the second embodiment is described. The method for manufacturing the printed wiring board 202 (203) of the exemplary variation of the second embodiment is different from that of the printed wiring board 200 (201) in that the inner diameter of the hole 261 of the through hole 260 in which the via 40 is formed is made smaller than that of the hole 61 (see FIG. 6) of the second embodiment. Herein, the printed wiring board 203 is a printed wiring board during the manufacturing process, i.e. a printed wiring board before the completion of the printed wiring board 202.

Accordingly, the method for manufacturing the printed wiring board 203 of the exemplary variation of the second embodiment is described assuming that similar process to the process as described with reference to FIG. 7A is performed on the printed wiring board 203. That is to say the plate resist part 250A (see FIG. 7A) is formed on the inner wall of the hole 262 following the formation of the hole 70 from the bottom surface 203B of the printed wiring board 203.

FIGS. 9A and 9B are diagrams illustrating cross sections of the printed wiring board 203 of the exemplary variation of the second embodiment during manufacturing processes, respectively. In FIGS. 9A and 9B, the size of the printed wiring board 203 is reduced compared with the printed wiring board 202 as illustrated in FIG. 8.

As illustrated in FIG. 9A, the through hole 260 which penetrates the printed wiring board 203 from the top surface 203A to the bottom surface 203B is formed by drilling the printed wiring board 203 from the top surface 203A or the bottom surface 203B, after the plate resist part 250A (see FIG. 7A) is formed on the inner wall of the hole 70 of the printed wiring board 203.

At this point, the central portion of the plate resist part 250A (see FIG. 7A) is penetrated, and then the plate resist part 250 is formed on the inner wall of the through hole 260 from the bottom surface 203B of the printed wiring board 203 (the bottom edge 260B of the through hole 260) to the bottom surface 23A of the conductive layer 23.

Since the inner diameter of the hole 261 is smaller than that of the through hole 60 (see FIG. 6) of the second embodiment, the convex portion 251 is formed under the bottom surface 23A of the conductive layer 23.

Herein, the inner diameter of the hole 262 in which the plate resist part 250 is formed is equal to that of the hole 62.

Next, as illustrated in FIG. 9B, the via 40 and the plated layers 30A, 30B and 30C are formed by forming the non-electrolytic plated layer and by forming the electrolytic plated layer on the non-electrolytic plated layer. Herein, the non-electrolytic plated layer is formed by impregnating the printed wiring board 203 with a non-electrolytic plate liquid solution.

Since the plate resist part 250 is formed on the inner wall of the through hole 260 from the bottom edge 260B of the through hole 260 to the bottom surface 23A of the conductive layer 23, the via 40 is not formed in a portion of the through hole 260 where the plate resist part 250 is formed.

The via 40 is formed on a portion of the inner wall of the through hole 260 where the plate resist part 250 is not formed. Accordingly, the via 40 is formed on the inner wall of the hole 261 which is located between the bottom surface 23A and the top edge 260A.

Accordingly, the bottom edge of the via 40 is connected to the conductive layer 23 which constitutes one of the inner layers, and the top edge of the via 40 is connected to the conductive layer 21 and the plated layer 30.

According to the processes as described above, the printed wiring board 202 as illustrated in FIG. 9B is completed. The printed wiring board 202 as illustrated in FIG. 9B is equal to the printed wiring board 202 as illustrated in FIG. 8.

The via 40 of the printed wiring board 202 is different from the via formed by the conventional method in that it becomes possible to suppress formation of the stub at the point where the via 40 is connected to the conductive layer 23 which constitutes one of the inner layers.

According to the exemplary variation of the second embodiment, it becomes possible to suppress formation of the via 40 in the portion of the through hole 260 lower than the bottom surface 23A of the conductive layer 23 by forming the plate resist part 250 from the bottom surface 202B of the printed circuit 202 (the bottom edge 260B of the through hole 260) to the bottom surface 23A of the conductive layer 23 with high dimensional accuracy. Thus, the formation of the stub at the point where the via 40 is connected to the conductive layer 23 is suppressed.

Therefore, according to the exemplary variation of the second embodiment, it becomes possible to provide the printed wiring board 202 which can suppress occurrence of reflection of a signal, noise or the like and which has enhanced transmission characteristics of high speed signals by suppressing the formation of the stub.

Since the machining process such as the back drilling method is not performed, the via 40 is not damaged during the manufacturing process and cutting scraps or the like do not remain in the through hole 260. Further, the diameter of the portion of the through hole 260 between the bottom edge 260B and the bottom surface 23A (the portion of the through hole 260 in which the via 40 is not formed) is not increased and the conductive layers 21 to 25 do not experience unexpected effects during the manufacturing process.

Thus, according to the exemplary variation of the second embodiment, it becomes possible to provide the printed wiring board 202 which has highly-enhanced transmission characteristics of the high speed signals compared with the conventional printed wiring board manufactured by the conventional method.

### <THIRD EMBODIMENT>

According to a printed wiring board 300 of the third embodiment, a method for forming a plate resist part 350 is different from that of the plate resist part 50 of the printed wiring board 100 of the first embodiment. Therefore, a shape of a through hole 360 is different from the shape of the through hole 60 of the first embodiment. Otherwise, the printed wiring board 300 according to the third embodiment is similar to the printed wiring board 100 of the first embodiment. Accordingly, the same elements as or elements similar to those of the printed wiring board 100 of the first embodiment are referred to by the same reference numerals, and a description thereof is omitted. Further, figures of the first embodiment may be incorporated herein.

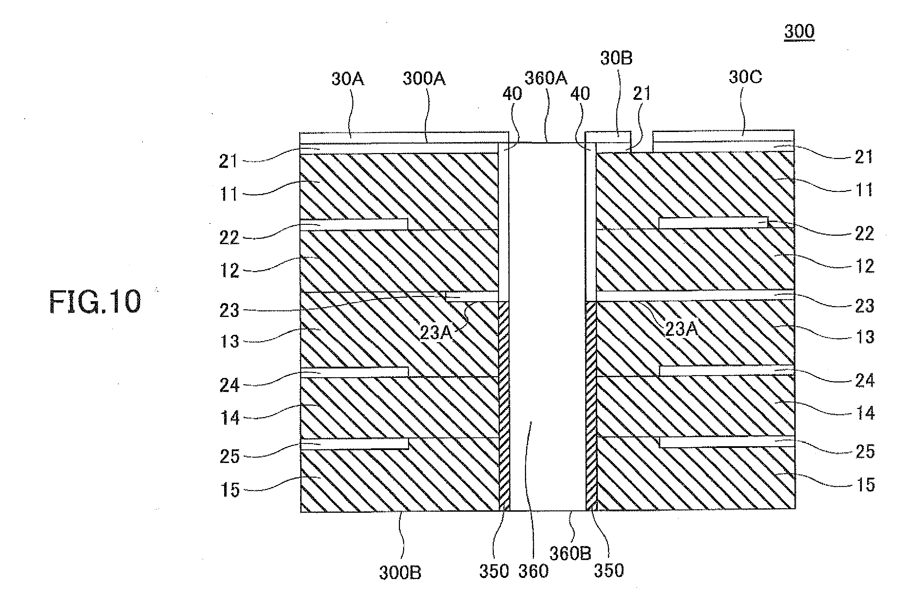

FIG. 10 is a diagram illustrating a cross section of the printed wiring board 300 of the third embodiment.

The printed wiring board 300 includes five insulating layers 11, 12, 13, 14 and 15, five conductive layers 21, 22, 23, 24 and 25, plated layers 30A, 30B and 30C, a via 40 and the plate resist part 350. The through hole 360 is formed in the printed wiring board 300. The through hole 360 penetrates the printed wiring board 300 from the top surface 300A to the bottom surface 300B. The via 40 and the plate resist part 350 are formed on the inner wall of the through hole 360, and are formed in cylindrical shapes along the inner wall, respectively. The configuration of the printed wiring board 300 is similar to that of the printed wiring board 100 of the first embodiment except for the plate resist part 350 and the through hole 360.

The through hole 360 is formed in the printed wiring board 300. The through hole 360 penetrates the printed wiring board 300 from the top surface 300A to the bottom surface 300B. The through hole 360 is formed in order to form the via 40 which connects the conductive layers 21 and 23. The inner diameter of the through hole 360 is constant from the top surface 300A to the bottom surface 300B.

Although the top surface of the conductive layer 21 is illustrated as the top surface 300A of the printed wiring board 300 in FIG. 10, the top surface of the insulating layer 11 becomes the top surface 300A of the printed wiring board 300 in a portion where the conductive layer 21 is not formed on the insulating layer 11.

Similarly, although the bottom surface of the insulating layer 15 is illustrated as the bottom surface 300B of the printed wiring board 300, a bottom surface of a conductive layer becomes the bottom surface 300B of the printed wiring board 300 in a portion where the conductive layer is formed on the bottom surface of the insulating layer 15.

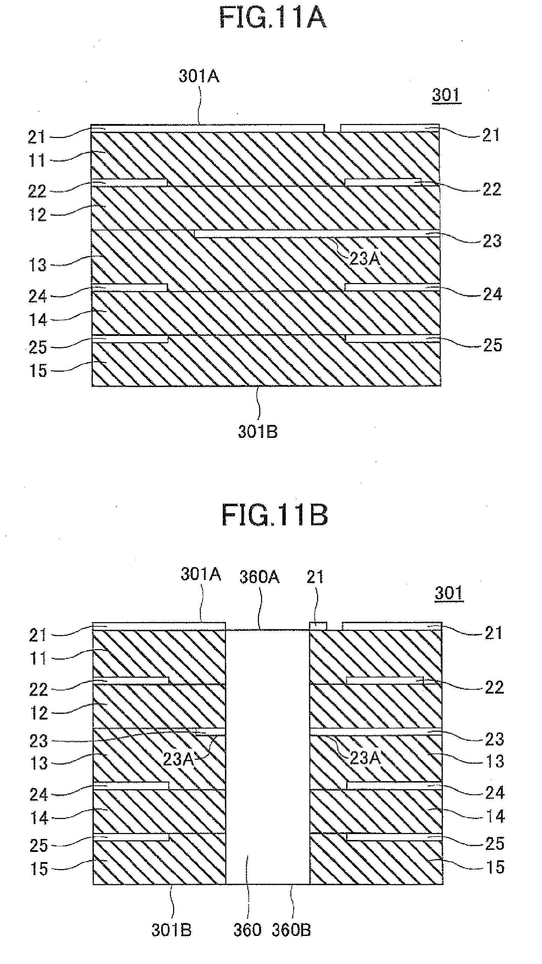

Herein, the inner diameter of the through hole 360 does not include the thicknesses of the via 40 and the plate resist part 350 (see FIG. 11B). The through hole 360 may be formed by drilling the printed wiring board 300.

At first, the plate resist part 350 is formed on the inner wall of the through hole 360 from the bottom surface 300B of the printed wiring board 300 (the bottom edge 360B of the through hole 360) to the bottom surface 23A of the conductive layer 23. Next, a non-electrolytic plated layer is formed on the inner wall of the through hole 360, and then an electrolytic plated layer is formed on the non-electrolytic layer. Accordingly, the via 40 is formed on the inner wall of the through hole 360 on which the plate resist part 350 is not formed.

The via 40 is one example of a cylindrical plated part which is formed on the inner wall of the through hole 360 by the non-electrolytic layer and the electrolytic layer. The via 40 is formed in a portion of the through hole 360 in which the plate resist part 350 is not formed. The portion in which the via 40 is formed is located from the top edge 360A of the through hole 360 to a portion which is located on the same level as the bottom surface 23A of the conductive layer 23.

Accordingly, the top edge of the via 40 is connected to the conductive layer 21, and the bottom edge of the via 4 0 is connected to the conductive layer 23. Thus, the conductive layer 21 which constitutes the top layer of the printed wiring board 300 and the conductive layer 23 which constitutes one of the inner layers of the printed wiring board 300 are connected by the via 40.

The plated layers 30A, 30B and 30C are formed on the conductive layer 21 in the plating process in which the via 40 is formed on the inner wall of the through hole 360. The plated layers 30A, 30B and 30C are patterned in a peripheral area of the top edge 360A of the through hole 360 in accordance with the pattern of the conductive layer 21 by using masks, resists or the like that are not illustrated in FIG. 10.

In FIG. 10, the plated layers 30A and 30B are connected to the via 40 and are connected to each other around the through hole 360 in plan view. The plated layer 30C is not connected to the plated layers 30A and 30B and the via 40.

Although the via 40 and the plated layers 30A and 30B are described above as a matter of practical convenience, the via 40 and the plated layers 30A and 30B are formed integrally. Hereinafter, the plated layers 30A, 30B and 30C may be referred to as a plated layer 30 in a case where the plated layers 30A, 30B and 30C are not distinguished.

The non-electrolytic plated layer and the electrolytic plated layer that constitute the via 40 and the plated layer 30 may be made of copper plate, for example. However, the via 40 and the plated layer 30 may not be limited to the copper plates, the via 40 and the plated layer 30 may be made of plates other than the copper plates. The via 40 and the plated layer 30 may be made of nickel plates, tin plates, zinc plates or the like, for example.

The plate resist part 350 is one example of a cylindrical plate resist part which is formed on the inner wall of the through hole 360 from the bottom surface 300B of the printed circuit 300 (the bottom edge 360B of the through hole 360) to the bottom surface 23A of the conductive layer 23.

Herein, forming the plate resist part 350 from the bottom surface 300B of the printed wiring board 300 (the bottom edge 360B of the through hole 360) to the bottom surface 23A of the conductive layer 23 means forming the plate resist part 350 from the bottom edge 360B of the through hole 360 to a portion at which the plate resist part 350 contacts with the bottom surface 23A of the conductive layer 23.

However, in a case where the plate resist part 350 does not contact the bottom surface 23A as illustrated in FIG. 10, forming the plate resist part 350 from the bottom surface 300B of the printed wiring board 300 (the bottom edge 360B of the through hole 360) to the bottom surface 23A of the conductive layer 23 means forming the plate resist part 350 from the bottom edge 360B of the through hole 360 to the bottom surface of the conductive layer 23 before the formation of the through hole 360 or to a virtual bottom surface of the conductive layer 23 which is located in the through hole 360.

Further, to be exact, there may be a case in which the plate resist part 350 does not contact with the bottom surface 23A of the conductive layer 23 or a case in which the plate resist part 350 is formed slightly over the bottom surface 23A, because of manufacturing error or the like. Even in these cases, the plate resist part 350 is treated as being formed on the inner wall of the through hole 360 from the bottom surface 300B of the printed wiring board 300 (the bottom edge 360B of the through hole 360) to the bottom surface 23A of the conductive layer 23.

A fluorine resin, a silicon resin or an olefin resin having poor non-electrolytic plate adhesion may be used as the plate resist part 350, for example.

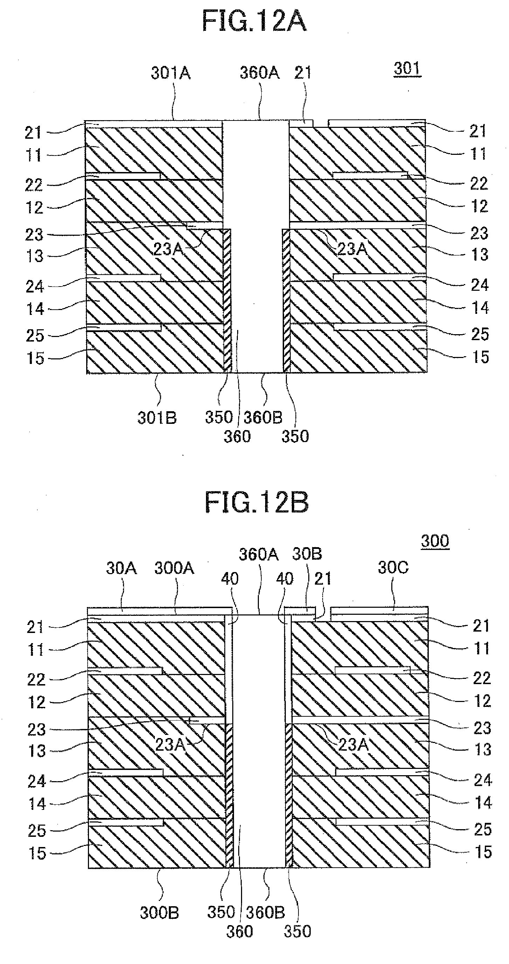

Next, the method for manufacturing the printed wiring board 300 of the third embodiment is described with reference to FIGS. 11A, 11B, 12A and 12B. Herein, a printed wiring board 301 is a printed wiring board during the manufacturing process, i.e. a printed wiring board before the completion of the printed wiring board 300.

FIGS. 11A, 11B, 12A and 12B are diagrams illustrating cross sections of the printed wiring board 301 of the third embodiment during the manufacturing processes. In FIGS. 11A, 11B, 12A and 12B, the size of the printed wiring board 301 is reduced compared with the printed wiring board 300 as illustrated in FIG. 10.

At first, as illustrated in FIG. 11A, the insulating layers 11, 12, 13, 14 and 15 and the conductive layers 21, 22, 23, 24 and 25 are stacked and interleaved with each other and adhered to each other by the thermosetting process, in order to form the printed wiring board 301.

Next, the through hole 360 is formed by drilling the printed circuit 301 from the top surface 301A to the bottom surface 301B.

In portions of the printed wiring board 301 as illustrated in FIGS. 11A and 11B, patterns of the conductive layers 21, 22, 23, 24 and 25 in plan view are determined by whether the conductive layers 21, 22, 23, 24 and 25 are connected to the via 40 or not.

For example, the conductive layers 22, 24 and 25 that are not connected to the via 40 have circular openings, respectively, that are larger than the through hole 360 in plan view, in order to keep away from the through hole 360. The through hole 360 and the conductive layers 22, 24 and 25 are designed and disposed in the printed wiring board 301 so that they are aligned in a concentric fashion in plan view. Although the conductive layers 21, 22, 24 and 25 are divided in two pieces in FIGS. 11A and 11B, the two pieces of the respective conductive layers 21, 22, 24 and 25 are connected with each other in reality.

Next, as illustrated in FIG. 12A, the plate resist part 350 is formed on the inner wall of the through hole 360 from the bottom surface 301B of the printed wiring board 301 (the bottom edge 360B of the through hole 360) to the bottom surface 23A of the conductive layer 23. In order to form the plate resist part 350, a brush, a sponge or the like to which a fluorine resin, silicon resin or olefin resin having poor non-electrolytic plate adhesion is applied may be prepared, for example. Then the brush or the like may be inserted into the through hole 360 from the bottom edge 360B, and rotated so that the fluorine resin, etc., may be applied on the inner wall of the hole 360. The plate resist part 350 may be formed by the processes as described above, for example.

In these processes, the plate resist part 350 may be formed on the inner wall of the through hole 360 by moving the brush, etc., from the bottom surface 301B of the printed wiring board 301 (the bottom edge 360B of the through hole 360) to the bottom surface 23A of the conductive layer 23 while rotating the brush, etc.

In this case, a drive mechanism of a drill which is used for forming the through hole 360 (see FIG. 11B) may be used as a drive mechanism which rotates the brush, etc., for example. Further, the drive mechanism of the drill may be used as a drive mechanism which moves the brush, etc., in a direction of the depth of the through hole 360.

It is possible to form the plate resist part 350 on the inner wall of the through hole 360 from the bottom surface 301B of the printed wiring board 301 (the bottom edge 360B of the through hole 360) to the bottom surface 23A of the conductive layer 23 by utilizing the drive mechanism of the drill as described above, for example.

Herein, the fluorine resin, the silicon resin or the olefin resin may be applied to the brush, the sponge or the like in a state where the fluorine resin, etc., is dissolved in a solvent, for example.

Next, as illustrated in FIG. 12B, the via 40 and the plated layers 30A, 30B and 30C are formed by forming the non-electrolytic plated layer and by forming the electrolytic plated layer on the non-electrolytic plated layer. Herein, the non-electrolytic plated layer is formed by impregnating the printed wiring board 301 with a non-electrolytic plate liquid solution.

Since the plate resist part 350 is formed on the inner wall of the through hole 360 from the bottom surface 300B of the printed wiring board 300 (the bottom edge 360B of the through hole 360) to the bottom surface 23A of the conductive layer 23, the via 40 is not formed in a portion of the through hole 360 where the plate resist part 350 is formed.

The via 40 is formed on a portion of the inner wall of the through hole 360 where the plate resist part 350 is not formed. Accordingly, the via 40 is formed on the inner wall of the through hole 360 between the bottom surface 23A and the top edge 360A.

Accordingly, the bottom edge of the via 40 is connected to the conductive layer 23 which constitutes one of the inner layers, and the top edge of the via 40 is connected to the conductive layer 21 and the plated layer 30.

According to the processes as described above, the printed wiring board 300 as illustrated in FIG. 12B is completed. The printed wiring board 300 as illustrated in FIG. 12B is equal to the printed wiring board 300 as illustrated in FIG. 10.

The via 40 of the printed wiring board 300 is different from the via formed by the conventional method in that it becomes possible to suppress formation of the stub at the point where the via 40 is connected to the conductive layer 23 which constitutes one of the inner layers.

According to the first embodiment, it becomes possible to suppress formation of the via 40 in the portion of the through hole 360 lower than the bottom surface 23A of the conductive layer 23 by forming the plate resist part 350 from the bottom surface 300B of the printed circuit 300 (the bottom edge 360B of the through hole 360) to the bottom surface 23A of the conductive layer 23 with high dimensional accuracy. Thus, the formation of the stub at the point where the via 40 is connected to the conductive layer 23 is suppressed.

Therefore, according to the third embodiment, it becomes possible to provide the printed wiring board 300 which can suppress occurrence of reflection of a signal, noise or the like and which has enhanced transmission characteristics of high speed signals by suppressing the formation of the stub.

Since the machining process such as the back drilling method is not performed, the via 40 is not damaged during the manufacturing process and cutting scraps or the like do not remain in the through hole 360. Further, the diameter of the portion of the through hole 360 between the bottom edge 360B and the bottom surface 23A (the portion of the through hole 360 in which the via 40 is not formed) is not increased and the conductive layers 21 to 25 do not experience unexpected effects during the manufacturing process.

Thus, according to the third embodiment, it becomes possible to provide the printed wiring board 300 which has highly-enhanced transmission characteristics of the high speed signals compared with the conventional printed wiring board manufactured by the conventional method.

### <FOURTH EMBODIMENT>

A printed wiring board 400 of the fourth embodiment is different from the printed wiring board 100 of the first embodiment in that two plate resist parts 450A and 450B are formed on an inner wall of a through hole 460 and a via 440 is formed on the inner wall of the through hole 460 between the plate resist parts 450A and 450B. Otherwise, the printed wiring board 400 according to the fourth embodiment is similar to the printed wiring board 100 of the first embodiment. Accordingly, the same elements as or elements similar to those of the printed wiring board 100 of the first embodiment are referred to by the same reference numerals, and a description thereof is omitted.

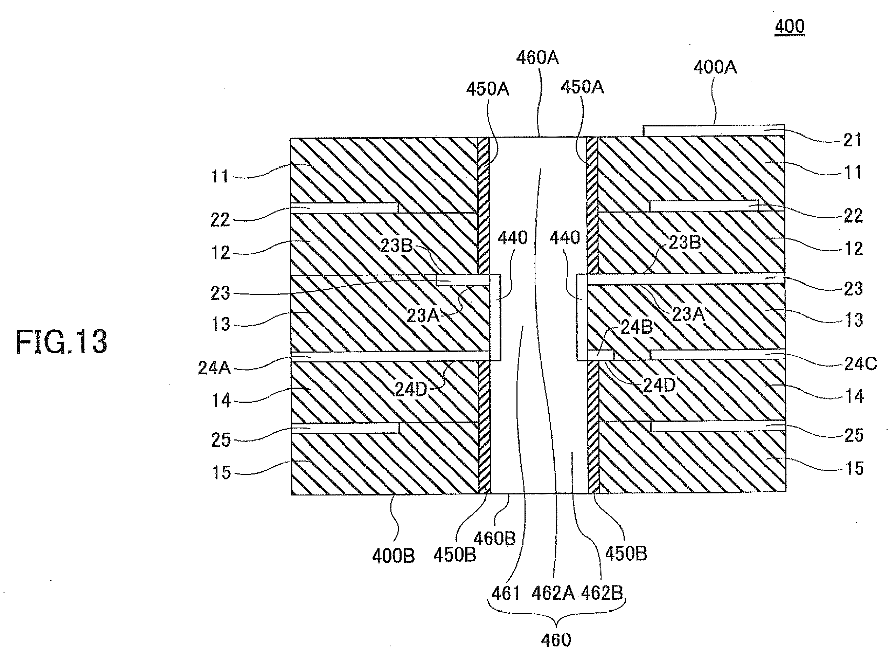

FIG. 13 is a diagram illustrating a cross section of the printed wiring board 400 of the fourth embodiment.

The printed wiring board 400 includes five insulating layers 11, 12, 13, 14 and 15, five conductive layers 21, 22, 23, 24A, 24B, 24C and 25, the via 440 and the plate resist parts 450A and 450B. The through hole 460 is formed in the printed wiring board 400. The through hole 460 penetrates the printed wiring board 400 from the top surface 400A to the bottom surface 400B. The via 440 and the plate resist parts 450A and 450B are formed on the inner wall of the through hole 460, and are formed in cylindrical shapes along the inner wall, respectively.

Although the top surface of the conductive layer 21 is illustrated as the top surface 400A of the printed wiring board 400 in FIG. 13, the top surface of the insulating layer 11 becomes the top surface 400A of the printed wiring board 400 in a portion where the conductive layer 21 is not formed on the insulating layer 11.

Similarly, although the bottom surface of the insulating layer 15 is illustrated as the bottom surface 400B of the printed wiring board 400, a bottom surface of a conductive layer becomes the bottom surface 400B of the printed wiring board 400 in a portion where the conductive layer is formed on the bottom surface of the insulating layer 15.

The through hole 460 includes a hole 461 in which the via 440 is formed and holes 462A and 462B in that the plate resist parts 450A and 450B are formed. The inner diameters of the hole 461 and holes 462A and 462B are different. The inner diameters of the holes 462A and 462B are larger than the inner diameter of the hole 461.

Herein, the holes 461, 462A and 462B are connected in this order from the top edge 460A to the bottom edge 460B of the through hole 460.

Herein, the inner diameters of the holes 461, 462A and 462B do not include the thickness of the via 440 and the plate resist parts 450A and 450B, respectively.

In a portion of the printed wiring board 400 as illustrated in FIG. 13, patterns of the conductive layers 21, 22, 23, 24 and 25 in plan view are determined by whether the conductive layers 21, 22, 23, 24 and 25 are connected to the via 440 or not.

For example, the conductive layer 21 among the conductive layers 21, 22 and 25 that are not connected to the via 440 is formed in a portion (right side of the top surface 400A in FIG. 13) away from the through hole 460. The conductive layer 21 may be used as a pad, for example. The conductive layers 22 and 25 have circular openings, respectively, that are larger than the through hole 460 in plan view, in order to keep away from the through hole 460. The through hole 460 and the conductive layers 22 and 25 are designed and disposed in the printed wiring board 400 so that they are aligned in a concentric fashion in plan view. Although the conductive layers 22 and 25 are divided in two pieces in FIG. 13, the two pieces of the respective conductive layers 22 and 25 are connected with each other in reality.

As for the conductive layers 24A, 24B and 24C, the conductive layers 24A and 24B are connected to each other in reality and are connected to the bottom edge of the via 440, respectively. The conductive layers 24C is not connected to the conductive layers 24A and 24B. Hereinafter, the conductive layers 24A, 24B and 24C may be referred to as a conductive layer 24 in a case where the conductive layers 24A, 24B and 24C are not distinguished.

The insulating layers 11, 12, 13, 14 and 15 and the conductive layers 21, 22, 23, 24 and 25 are adhered to each other by a thermosetting process which is treated in a situation where the conductive layers 22 and 23 and the conductive layers 24 and 25 are formed on opposing surfaces of the insulating layers 12 and 14 that constitute the core layers, respectively.

Herein, a cross section of a portion of the printed wiring board 400 is illustrated as a matter of practical convenience in FIG. 13. A conductive layer may be formed on the bottom surface 400B of the printed wiring board 400 in a portion that is not illustrated in FIG. 13. The printed wiring board 400 may include plural of through holes 460.

The through hole 460 is formed in the printed wiring board 400. The through hole 460 penetrates the printed wiring board 400 from the top surface 400A to the bottom surface 400B. The through hole 460 is formed in order to form the via 440 thereinto which connects the conductive layers 23 and 24.

At first, the plate resist part 450A is formed on the inner wall of the through hole 460 from the top surface 400A of the printed wiring board 400 (the top edge 460A of the through hole 460) to the top surface 23B of the conductive layer 23, and the plate resist part 450B is formed on the inner wall of the through hole 460 from the bottom surface 400B of the printed wiring board 400 (the bottom edge 460B of the through hole 460) to the bottom surface 24D of the conductive layer 24.

Next, a non-electrolytic plated layer is formed on the inner wall of the through hole 460, and then an electrolytic plated layer is formed on the non-electrolytic layer. Accordingly, the via 440 is formed on the inner wall of the through hole 460 on which the plate resist parts 450A and 450B are not formed.

As described above, in the through hole 460, the inner diameters of the holes 462A and 462B in that the plate resist parts 450A and 450B are formed, respectively, are larger than the inner diameter of the hole 461 in which the via 440 is formed. A method for forming the through hole 460 will be described later.

The via 440 is one example of a cylindrical plated part which is formed on the inner wall of the through hole 460 by the non-electrolytic layer and the electrolytic layer. The via 440 is formed on the inner wall of a portion of the through hole 460 on which the plate resist parts 450A and 450B are not formed. That is to say the via 440 is formed on the inner wall of the through hole 460 between a point as high as the top surface 23B of the conductive layer 23 and a point as low as the bottom surface 24D of the conductive layer 24.

Accordingly, the top edge of the via 440 is connected to the conductive layer 23, and the bottom edge of the via 440 is connected to the conductive layers 24A and 24B. Thus, the conductive layer 23 and the conductive layers 24A and 24B are connected by the via 440. Each of the conductive layers 23, 24A and 24B constitutes one of the inner layers of the printed wiring board 400.

The non-electrolytic plated layer and the electrolytic plated layer that constitute the via 440 may be made of copper plate, for example. However, the via 440 may not be limited to the copper plate, the via 440 may be made of plate other than the copper plate. The via 440 may be made of nickel plate, tin plate, zinc plate or the like, for example.

The plate resist part 450B is one example of a cylindrical plate resist part which is formed on the inner wall of the through hole 460 from the bottom surface 400B of the printed circuit 400 (the bottom edge 460B of the through hole 460) to the bottom surface 24D of the conductive layer 24.

The plate resist part 450A is one example of a cylindrical plate resist part which is formed on the inner wall of the through hole 460 from the top surface 400A of the printed circuit 400 (the top edge 460A of the through hole 460) to the top surface 23B of the conductive layer 23.

A fluorine resin, a silicon resin or an olefin resin having poor non-electrolytic plate adhesion may be used as the plate resist parts 450A and 450B, respectively, for example.

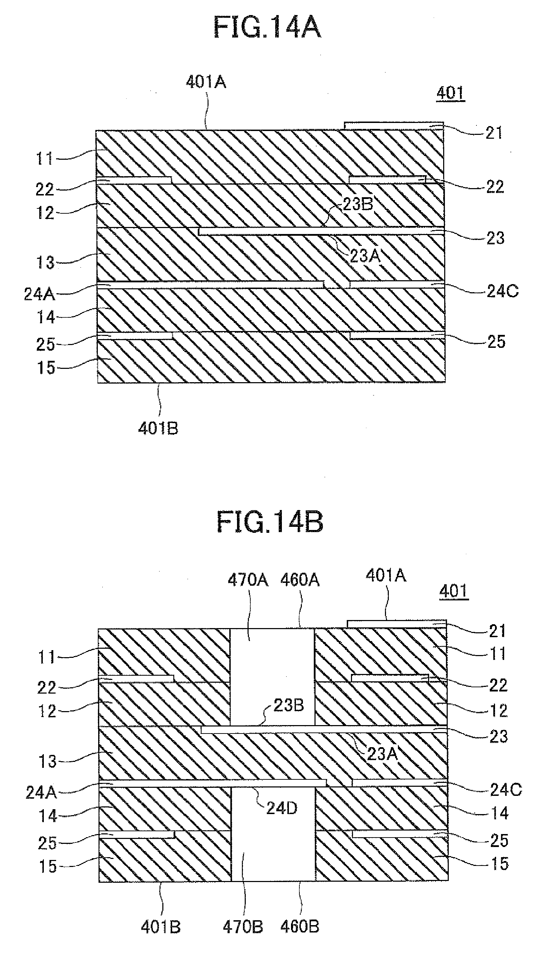

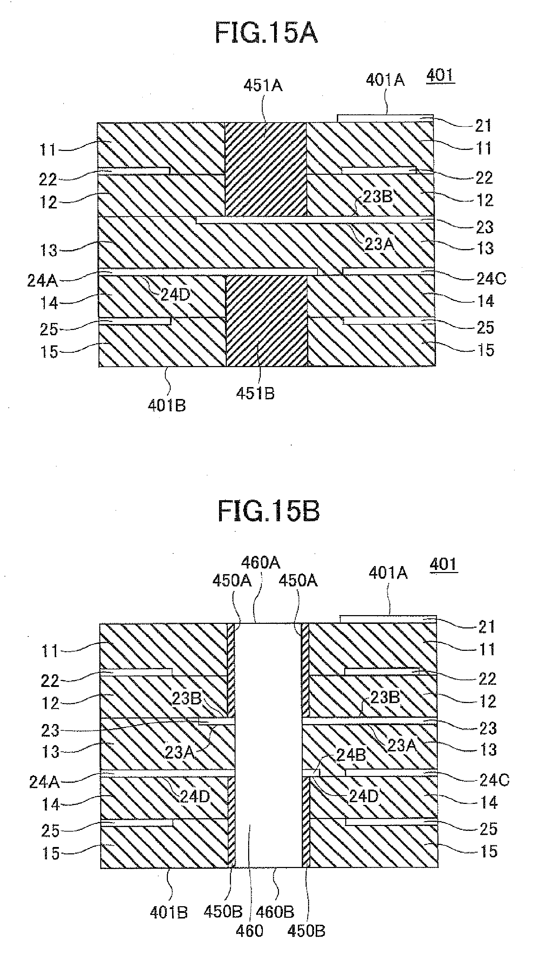

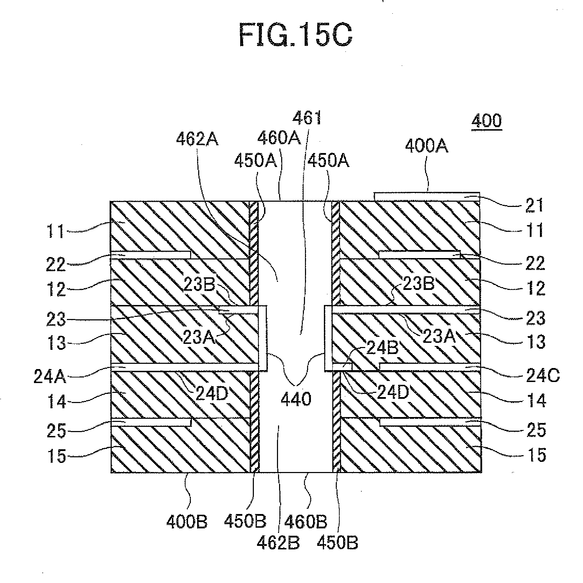

Next, the method for manufacturing the printed wiring board 400 (401) of the fourth embodiment is described with reference to FIGS. 14A, 14B, 15A, 15B and 15C. Herein, a printed wiring board 401 is a printed wiring board during the manufacturing process, i.e. a printed wiring board before the completion of the printed wiring board 400.

FIGS. 14A, 14B, 15A, 15B and 15C are diagrams illustrating cross sections of the printed wiring board 401 of the fourth embodiment during the manufacturing process. In FIGS. 14A, 14B, 15A, 15B and 15C, the size of the printed wiring board 401 is reduced compared with the printed wiring board 400 as illustrated in FIG. 13.

At first, as illustrated in FIG. 14A, the insulating layers 11, 12, 13, 14 and 15 and the conductive layers 21, 22, 23, 24 and 25 are stacked and interleaved with each other and adhered to each other by the thermosetting process, in order to form the printed wiring board 401.

Next, as illustrated in FIG. 14B, holes 470A and 470B are formed by laser beam machining or the like that is performed from the top surface 401A and the bottom surface 401B of the printed wiring board 401, respectively. The laser machining is performed until the hole 470A reaches the top surface 23B of the conductive layer 23. In this process, portions of the insulating layers 11 and 12 are removed as illustrated in FIG. 14B. Similarly, the laser machining is performed until the hole 470B reaches the bottom surface 24D of the conductive layer 24. In this process, portions of the insulating layers 14 and 15 are removed as illustrated in FIG. 14B.

For example, it is possible to start the laser machining from the top surface 401A of the printed wiring board 401 and to stop the laser machining at the top surface 23B of the conductive layer 23 by setting laser power of a CO₂ laser to a designated value which is optimized for removing the portions of the insulating layers 11 and 12.

Similarly, for example, it is possible to start the laser machining from the bottom surface 401B of the printed wiring board 401 and to stop the laser machining at the bottom surface 24D of the conductive layer 24 by setting laser power of the CO₂ laser to a designated value which is optimized for removing the portions of the insulating layers 14 and 15.

Herein, it is necessary to apply more laser power for removing the conductive layers 23 and 24 than for removing the insulating layers 11, 12, 14 and 15. Accordingly, the laser power of the laser machining may be set to a value which is enough for removing the insulating layers 11, 12, 14 and 15 and is less than the laser power that is necessary for removing the conductive layers 23 and 24.

As described above, it is possible to form the hole 470A which reaches the top surface 23B of the conductive layer 23 from the top surface 401A of the printed wiring board 401 and the hole 470B which reaches the bottom surface 24D of the conductive layer 24 from the bottom surface 401B of the printed wiring board 401.

The holes 470A and 470B are formed at positions where the through hole 460 is to be formed later, so that the holes 470A and 470B and the through hole 460 are aligned in a concentric fashion in plan view.

The inner diameters of the holes 470A and 470B may be set to values that are larger than the inner diameter of the through hole 460 by the thicknesses of the plate resist parts 450A and 450B, respectively, in view of forming the plate resist parts 450A and 450B later.

Next, as illustrated in FIG. 15A, plate resist parts 451A and 451B are formed by supplying plate resist into the holes 470A and 470B, respectively (see FIG. 14B). The plate resist part 451A is formed in the hole 470A from the top surface 23B of the conductive layer 23 to the top surface 401A of the printed wiring board 401. The plate resist part 451B is formed in the hole 470B from the bottom surface 24D of the conductive layer 24 to the bottom surface 401B of the printed wiring board 401.

A fluorine resin, silicon resin or olefin resin having poor non-electrolytic plate adhesion may be used as the plate resist, for example.

Next, as illustrated in FIG. 15B, the through hole 460 which penetrates the printed wiring board 401 from the top surface 401A to the bottom surface 401B is formed by drilling the printed wiring board 401 from the top surface 401A or the bottom surface 401B.

At this stage, the plate resist part 450A is formed on the inner wall of the through hole 460 from the top edge 460A of the through hole 460 to the top surface 23B of the conductive layer 23, and the plate resist part 450B is formed on the inner wall of the through hole 460 from the bottom edge 460B of the through hole 460 to the bottom surface 24D of the conductive layer 24.

Next, as illustrated in FIG. 15C, the via 440 is formed by forming the non-electrolytic plated layer and by forming the electrolytic plated layer on the non-electrolytic plated layer. Herein, the non-electrolytic plated layer is formed by impregnating the printed wiring board 401 with a non-electrolytic plate liquid solution.

Since the plate resist parts 450A and 450B are formed on the inner wall of the through hole 460 from the top edge 460A of the through hole 460 to the top surface 23B of the conductive layer 23 and from the bottom edge 460B of the through hole 460 to the bottom surface 24D of the conductive layer 24, respectively, the via 440 is not formed in portions of the through hole 460 where the plate resist parts 450A and 450B are formed, respectively.

The via 440 is formed on the inner wall of a portion of the through hole 460 on which the plate resist parts 450A and 450B are not formed. That is to say the via 440 is formed on the inner wall of the through hole 460 between a point as high as the top surface 23B of the conductive layer 23 and a point as low as the bottom surface 24D of the conductive layer 24.

Accordingly, the top edge of the via 440 is connected to the conductive layer 23 and the bottom edge of the via 440 is connected to the conductive layer 24, respectively.

According to the processes as described above, the printed wiring board 400 as illustrated in FIG. 15C is completed. The printed wiring board 400 as illustrated in FIG. 15C is equal to the printed wiring board 400 as illustrated in FIG. 13.

The via 440 of the printed wiring board 400 is different from the via formed by the conventional method in that it becomes possible to suppress formation of the stub at the point where the via 440 is connected to the conductive layers 23 and 24 that constitute the inner layers.

According to the fourth embodiment, it becomes possible to suppress formation of the via 440 in the portion of the through hole 460 higher than the top surface 23B of the conductive layer 23 by forming the plate resist part 450A from the top surface 400A of the printed circuit 400 (the top edge 460A of the through hole 460) to the top surface 23B of the conductive layer 23 with high dimensional accuracy. Thus, the formation of the stub at the point where the via 440 is connected to the conductive layer 23 is suppressed.

In addition to this, according to the fourth embodiment, it becomes possible to suppress formation of the via 440 in the portion of the through hole 460 lower than the bottom surface 24D of the conductive layer 24 by forming the plate resist part 450B from the bottom surface 400B of the printed circuit 400 (the bottom edge 460B of the through hole 460) to the bottom surface 24D of the conductive layer 24 with high dimensional accuracy. Thus, the formation of the stub at the point where the via 440 is connected to the conductive layer 24 is suppressed.

Therefore, according to the fourth embodiment, it becomes possible to provide the printed wiring board 400 which can suppress occurrence of reflection of a signal, noise or the like and which has enhanced transmission characteristics of high speed signals by suppressing the formation of the stub.

Since the machining process such as the back drilling method is not performed, the via 440 is not damaged during the manufacturing process and cutting scraps or the like do not remain in the through hole 460. Further, the diameters of the portions of the through hole 460 between the top edge 460A and the top surface 23B of the conductive layer 23 and between the bottom edge 460B and the bottom surface 24D, respectively, are not increased and the conductive layers 21 to 25 do not experience unexpected effects during the manufacturing process.

Thus, according to the fourth embodiment, it becomes possible to provide the printed wiring board 400 which has highly-enhanced transmission characteristics of the high speed signals compared with the conventional printed wiring board manufactured by the conventional method.

### <FIFTH EMBODIMENT>

A printed wiring board 500 of the fifth embodiment is different from the printed wiring board 100 of the first embodiment in that two plate resist parts 550A and 550B are formed on an inner wall of a through hole 560 and two vias 540A and 540B are formed on the inner wall of the through hole 560. Otherwise, the printed wiring board 500 according to the fifth embodiment is similar to the printed wiring board 100 of the first embodiment. Accordingly, the same elements as or elements similar to those of the printed wiring board 100 of the first embodiment are referred to by the same reference numerals, and a description thereof is omitted.

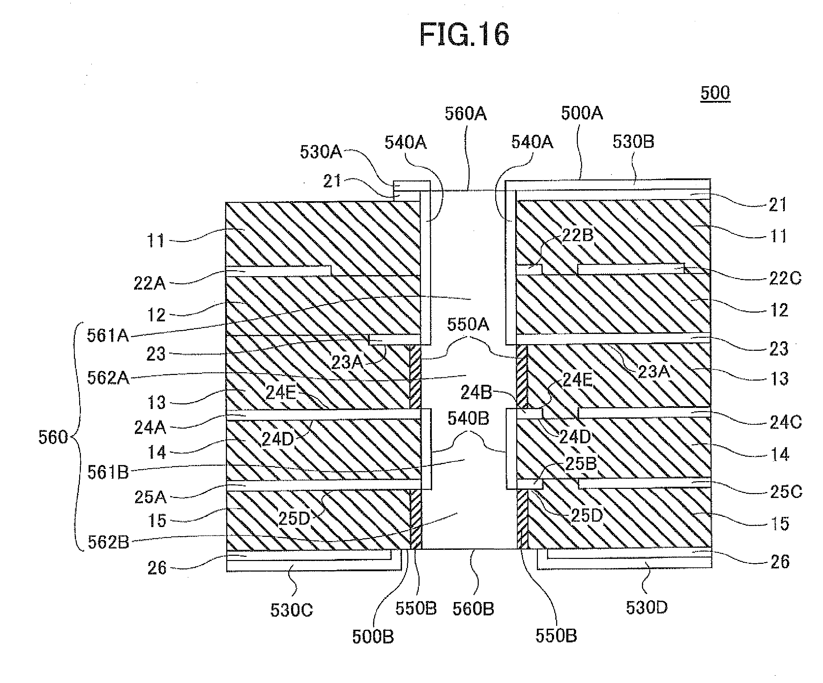

FIG. 16 is a diagram illustrating a cross section of the printed wiring board 500 of the fifth embodiment.

The printed wiring board 500 includes five insulating layers 11, 12, 13, 14 and 15, six conductive layers 21, 22A, 22B, 22C, 23, 24A, 24B, 24C, 25A, 25B, 25C and 26, plated layers 530A, 530B, 530C and 530D, the vias 540A and 540B and the plate resist parts 550A and 550B.

The through hole 560 is formed in the printed wiring board 500. The through hole 560 penetrates the printed wiring board 500 from the top surface 500A to the bottom surface 500B. The vias 540A and 540B and the plate resist parts 550A and 550B are formed on the inner wall of the through hole 560, and are formed in cylindrical shapes along the inner wall, respectively.

Although the top surface of the conductive layer 21 is illustrated as the top surface 500A of the printed wiring board 500 in FIG. 16, the top surface of the insulating layer 11 becomes the top surface 500A of the printed wiring board 500 in a portion where the conductive layer 21 is not formed on the insulating layer 11.

Similarly, in FIG. 16, the bottom surface of the conductive layer 26 becomes the bottom surface 500B of the printed wiring board 500 in a portion where the conductive layer 26 is formed on the bottom surface of the insulating layer 15, and the bottom surface of the insulating layer 15 becomes the bottom surface 500B of the printed wiring board 500 in a portion where the conductive layer 26 is not formed on the bottom surface of the insulating layer 15 such as a portion around the bottom edge 560B of the through hole 560.

The through hole 560 includes holes 561A and 561B in that the vias 540A and 540B are formed, and holes 562A and 562B in that the plate resist parts 550A and 550B are formed, respectively.

The inner diameters of the holes 561A and 561B and the inner diameters of the holes 562A and 562B are different. The inner diameters of the holes 562A and 562B are larger than the inner diameters of the holes 561A and 561B. Herein, the inner diameters of the holes 561A and 561B are equal to each other. Similarly, the inner diameters of the holes 562A and 562B are equal to each other.

Herein, the holes 561A, 561B, 562A and 562B are connected in the order of the holes 561A, 562A, 561B and 562B from the top edge 560A to the bottom edge 560B of the through hole 560.

Herein, the inner diameters of the holes 561A, 561B, 562A and 562B do not include the thicknesses of the vias 540A and 540B and the plate resist parts 550A and 550B, respectively.

In a portion of the printed wiring board 500 as illustrated in FIG. 16, patterns of the conductive layers 21, 22A, 22B, 22C, 23, 24A, 24B, 24C, 25A, 25B, 25C and 26 in plan view are determined by whether the conductive layers 21, 22A, 22B, 22C, 23, 24A, 24B, 24C, 25A, 25B, 25C and 26 are connected to any of the vias 540A and 540B or not.

For example, the conductive layers 24C and 25C among the conductive layers 24C, 25C and 26 that are not connected to any of the vias 540A and 540B is formed in a portion away from the through hole 560. The conductive layer 26 has a circular opening which is larger than the through hole 560 in plan view, in order to keep away from the through hole 560. The through hole 560 and the conductive layer 26 are designed and disposed in the printed wiring board 500 so that they are aligned in a concentric fashion in plan view. Although the conductive layers 21 and 23 are divided in two pieces in FIG. 16, the two pieces of the respective conductive layers 21 and 23 are connected with each other in reality.

As for the conductive layers 22A, 22B, 24A, 24B, 25A and 25B, the conductive layers 22A and 22B are connected to each other. The conductive layer 22B is connected to the middle portion of the via 540A. The conductive layers 24A and 24B are connected to each other and are connected to the top edge of the via 540B. The conductive layers 25A and 25B are connected to each other and are connected to the bottom edge of the via 540B.

Hereinafter, the conductive layers 22A, 22B and 22C may be referred to as a conductive layer 22 in a case where the conductive layers 22A, 22B and 22C are not distinguished. Similarly, the conductive layers 24A, 24B and 24C may be referred to as a conductive layer 24 in a case where the conductive layers 24A, 24B and 24C are not distinguished. The conductive layers 25A, 25B and 25C may be referred to as a conductive layer 25 in a case where the conductive layers 25A, 25B and 25C are not distinguished.

The insulating layers 11, 12, 13, 14 and 15 and the conductive layers 21, 22, 23, 24 and 25 are adhered to each other by a thermosetting process which is treated in a situation where the conductive layers 22 and 23 and the conductive layers 24 and 25 are formed on opposing surfaces of the insulating layers 12 and 14 that constitute the core layers, respectively.

Herein, a cross section of a portion of the printed wiring board 500 is illustrated as a matter of practical convenience in FIG. 16. The printed wiring board 500 may include plural of the through holes 560.

The through hole 560 is formed in the printed wiring board 500. The through hole 560 penetrates the printed wiring board 500 from the top surface 500A to the bottom surface 500B. The through hole 560 is formed in order to form the vias 540A and 540B that connect the conductive layers 21, 22 and 23 and the conductive layers 24 and 25, respectively. A method for forming the vias 540A and 540B, the plate resist parts 550A and 550B and the through hole 560 will be described later.

Each of the vias 540A and 540B is one example of a cylindrical plated part which is formed on the inner wall of the through hole 560 by the non-electrolytic layer and the electrolytic layer. The vias 540A and 540B are formed in portions of the through hole 560 where the plate resist parts 550A and 550B are not formed, respectively.

Thus, the via 540A connects the conductive layers 21, 22 and 23, and the via 540B connects the conductive layers 24 and 25.

The plated layers 530A and 530B are connected to the via 540A. The plated layers 530C and 530D are formed on the conductive layer 26, i.e. on the bottom surface 500B of the printed wiring board 500.

The plated layers 530A, 530B, 530C and 530D are formed in the same plating process as the plating process for forming the vias 540A and 540B.

The non-electrolytic plated layer and the electrolytic plated layer that constitute the vias 540A and 540B and the plated layers 530A, 530B, 530C and 530D may be made of copper plate, for example. However, the vias 540A and 540B may not be limited to the copper plates, the vias 540A and 540B may be made of plates other than the copper plates. The vias 540A and 540B may be made of nickel plates, tin plates, zinc plates or the like, for example.

The plate resist part 550B is one example of a cylindrical plate resist part which is formed on the inner wall of the through hole 560 from the bottom surface 500B of the printed circuit 500 (the bottom edge 560B of the through hole 560) to the bottom surface 25D of the conductive layer 25.

The plate resist part 550A is one example of a cylindrical plate resist part which is formed on the inner wall of the through hole 560 from the bottom surface 23A of the conductive layer 23 to the top surface 24D of the conductive layer 24.

A fluorine resin, a silicon resin or an olefin resin having poor non-electrolytic plate adhesion may be used as the plate resist parts 550A and 550B, respectively, for example.

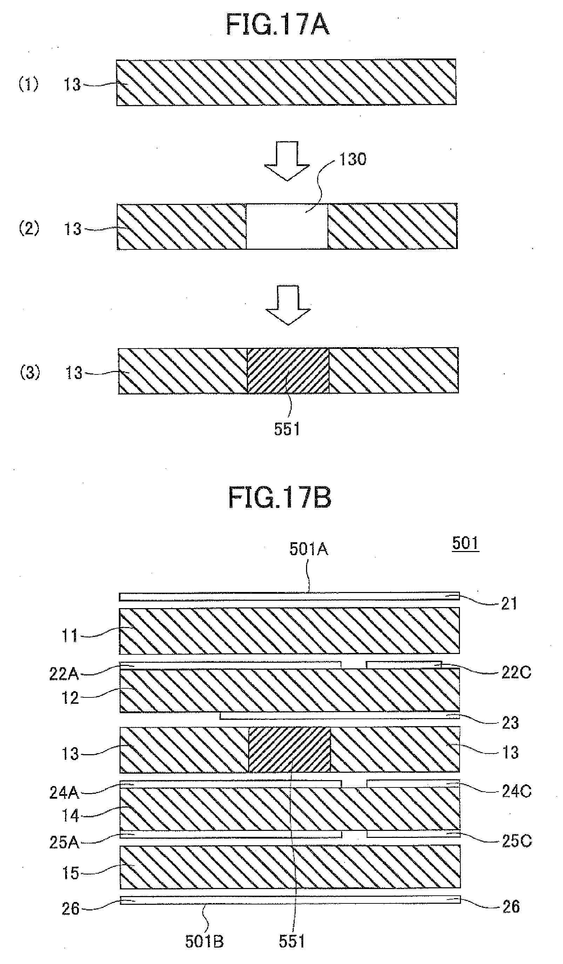

Next, the method for manufacturing the printed wiring board 500 of the fifth embodiment is described with reference to FIGS. 17A, 17B, 18A, 18B, 19A and 19B. Herein, a printed wiring board 501 is a printed wiring board during the manufacturing process, i.e. a printed wiring board before the completion of the printed wiring board 500.

FIGS. 17A, 17B, 18A, 18B, 19A and 19B are diagrams illustrating cross sections of the printed wiring board 501 of the fifth embodiment during the manufacturing process. In FIGS. 17A, 17B, 18A, 18B, 19A and 19B, the size of the printed wiring board 501 is reduced compared with the printed wiring board 500 as illustrated in FIG. 16.

At first, the insulating layer 13 is prepared as illustrated in FIG. 17A (1). The insulating layer 13 may be a prepreg layer, for example. Next, as illustrated in FIG. 17A (2), a through hole 130 is formed in a portion of the insulating layer 13. The through hole 130 is larger than the through hole 560 which is formed later in plan view. The shape of the through hole 130 in plan view may not be limited to a circle, the shape may be rectangular, for example. The through hole 130 may be formed by a machining process such as drilling or by wet etching process, for example.

Next, the through hole 130 is filled with a plate resist part 551 as illustrated in FIG. 17A (3).

Next, as illustrated in FIG. 17B, the insulating layers 11, 12, 13, 14 and 15 and the conductive layers 21, 22, 23, 24 and 25 are stacked and interleaved with each other and adhered to each other by the thermosetting process, in order to form the printed wiring board 501. The through hole 130 (see FIG. 17A) of the insulating layer 13 is filled with the plate resist part 551.

The plate resist part 551 constitutes a plate resist part which becomes the plate resist part 550A after the through hole 560 is formed through the plate resist part 551. Therefore, the plate resist part 551 is aligned and formed at a position in the insulating layer 13, so that the plate resist part 551 includes a portion in which the through hole 560 is to be formed later.

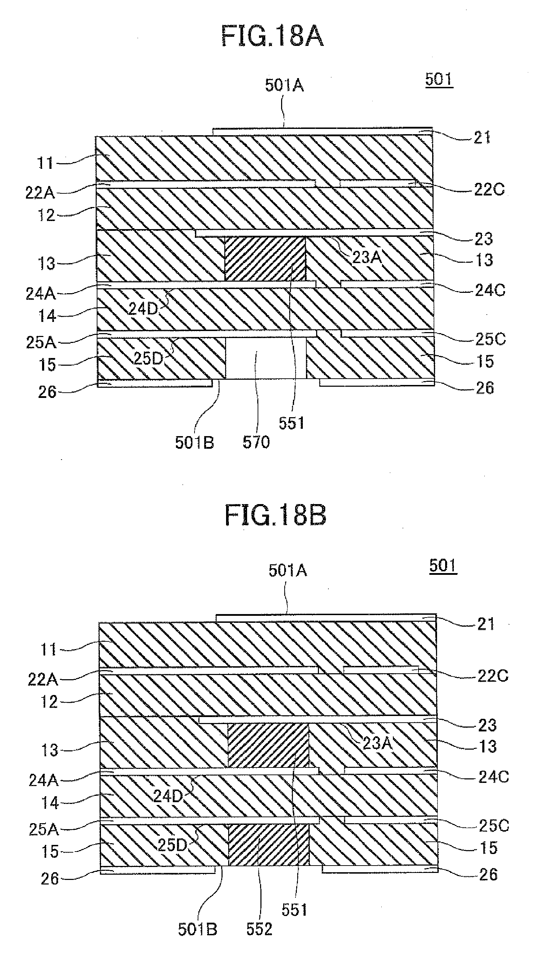

Next, as illustrated in FIG. 18A, a hole 570 is formed by laser beam machining or the like that is performed from the bottom surface 501B of the printed wiring board 501. The laser machining is performed until the hole 570 reaches the bottom surface 25D of the conductive layer 25 after a portion of the conductive layer 26 is removed. In this process, a portion of the insulating layer 15 is removed as illustrated in FIG. 18A.

For example, the laser machining is performed in order to remove the portion of the conductive layer 26 by setting laser power of a CO₂ laser to a designated value which is optimized for removing the portion of the conductive layer 26. Then, it is possible to start the laser machining from the bottom surface 501B of the printed wiring board 501 and to stop the laser machining at the bottom surface 25D of the conductive layer 25 by setting laser power of CO₂ laser to a designated value which is optimized for removing the portions of the insulating layer 15.

Herein, it is necessary to apply more laser power for removing the conductive layer 25 than for removing the insulating layer 15. Accordingly, the laser power of the laser machining may be set to a value which is enough for removing the insulating layer 15 and is less than the laser power that is necessary for removing the conductive layer 25.

Thus, it is possible to form the hole 570 which reaches the bottom surface 25D of the conductive layer 25 from the bottom surface 501B of the printed wiring board 501.

The hole 570 is aligned and formed at a position in the insulating layer 15, so that the hole 570 includes a portion in which the through hole 560 is to be formed later. The hole 570 is to be filled with a plate resist which is used for forming the plate resist part 550B later.

In a case where the planar shape of the hole 570 is a circle, the inner diameter of the hole 570 may be set to a value which is larger than the inner diameter of the through hole 560 by the thickness of the plate resist part 550B, in view of forming the plate resist part 550B later.

In a case where the planar shape of the hole 570 is a rectangular shape, a planar dimension of the hole 570 may be set to a value which is larger than the inner diameter of the through hole 560, in view of forming the plate resist part 550B later.

Next, as illustrated in FIG. 18B, a plate resist part 552 is formed by supplying a plate resist into the hole 570 (see FIG. 18A). The plate resist part 552 is formed from the bottom surface 501B of the printed wiring board 501 to the bottom surface 25D of the conductive layer 25.

A fluorine resin, silicon resin or olefin resin having poor non-electrolytic plate adhesion may be used as the plate resist, for example.

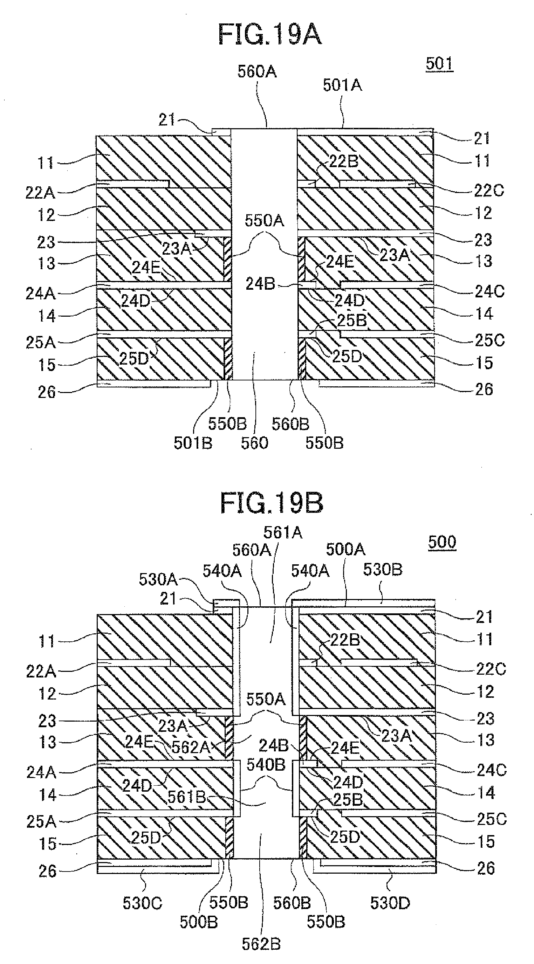

Next, as illustrated in FIG. 19A, the through hole 560 which penetrates the printed wiring board 501 from the top surface 501A to the bottom surface 501B is formed by drilling the printed wiring board 501 from the top surface 501A or the bottom surface 501B.

At this point, the plate resist part 550A is formed on the inner wall of the through hole 560 from the bottom surface 23A of the conductive layer 23 to the top surface 24E of the conductive layer 24. The plate resist part 550B is formed on the inner wall of the through hole 560 from the bottom surface 501B of the printed wiring board 501 (the bottom edge 560B of the through hole 560) to the bottom surface 25D of the conductive layer 25.

Next, as illustrated in FIG. 19B, the vias 540A and 540B are formed by forming the non-electrolytic plated layers and by forming the electrolytic plated layers on the non-electrolytic plated layers. Herein, the non-electrolytic plated layers are formed by impregnating the printed wiring board 501 with a non-electrolytic plate liquid solution.

The plate resist part 550A is formed on the inner wall of the through hole 560 from the bottom surface 23A of the conductive layer 23 to the top surface 24E of the conductive layer 24, and the plate resist part 550B is formed on the inner wall of the through hole 560 from the bottom edge 560B of the through hole 560 to the bottom surface 25D of the conductive layer 25 Thus, the vias 540A and 540B are not formed in portions of the through hole 560 where the plate resist parts 550A and 550B are formed.

The vias 540A and 540B are formed in portions of the through hole 560 where the plate resist parts 550A and 550B are not formed.

Thus, the via 540A is connected to the conductive layers 21, 22 and 23, and the via 540B is connected to the conductive layers 24 and 25.

According to the processes as described above, the printed wiring board 500 as illustrated in FIG. 19B is completed. The printed wiring board 500 as illustrated in FIG. 19B is equal to the printed wiring board 500 as illustrated in FIG. 16.

The vias 540A and 540B of the printed wiring board 500 are different from the via formed by the conventional method in that it becomes possible to suppress formation of the stub at the point where the via 540A is connected to the conductive layer 23 which constitutes an inner layer and the via 540B is connected to the conductive layers 24 and 25 that constitute other inner layers.

According to the fifth embodiment, it becomes possible to suppress formation of the vias 540A and 540B in the portions of the through hole 560 between the bottom surface 23A of the conductive layer 23 and the top surface 24E of the conductive layer 24 by forming the plate resist part 550A between the bottom surface 23A and the top surface 24E with high dimensional accuracy. Thus, the formation of the stub at the point where the via 540A is connected to the conductive layer 23 and the point where the via 540B is connected to the conductive layer 24 is suppressed. The plate resist part 550A is formed from the plate resist part 551 (see FIG. 17A) which is supplied in the through hole 130 before the insulating layer 13 (prepreg layer) is adhered with the insulating layers 11, 12, 14 and 15 and the conductive layers 21, 22, 23, 24 and 26.

The conductive layer 23 is adhered on the top surface of the insulating layer 13 (prepreg layer), and the conductive layer 24 is adhered on the bottom surface of the insulating layer 13 (see FIG. 17B). Therefore, it becomes possible to form the plate resist part 550A in the through hole 560 between the bottom surface 23A and the top surface 24E with high dimensional accuracy by forming the through hole 560 in the center portion of the plate resist part 551 which penetrates through the insulating layer 13.

Thus, it becomes possible to suppress the formation of the stub at the bottom edge of the via 540A and the top edge of the via 540B.

Further, according to the fifth embodiment, it becomes possible to suppress formation of the via 540B in the portions of the through hole 560 between the bottom surface 500B of the printed wiring board 500 and the bottom surface 25D of the conductive layer 25 by forming the plate resist part 550B from the bottom surface 500B to the bottom surface 25D with high dimensional accuracy. Thus, the formation of the stub at the point where the via 540B is connected to the conductive layer 25 is suppressed.

As described above, the hole 570 (see FIG. 18A) is formed from the bottom surface 501B of the printed wiring board 501 to the bottom surface 25D of the conductive layer 25 by laser machining, and then the plate resist part 550B is formed from the plate resist part 552 (see FIG. 18B) which is supplied in the hole 570.

Thus, it becomes possible to form the plate resist part 550B from the bottom surface 500B of the printed wiring board 500 (the bottom edge 560B of the through hole 560) to the bottom surface 25D of the conductive layer 25 with high dimensional accuracy.

Therefore, according to the fifth embodiment, it becomes possible to provide the printed wiring board 500 which can suppress occurrence of reflection of a signal, noise or the like and which has enhanced transmission characteristics of high speed signals by suppressing the formation of the stub.

Since the machining process such as the back drilling method is not performed, the vias 540A and 540B are not damaged during the manufacturing process and cutting scraps or the like do not remain in the through hole 560. Further, the inner diameters of the portions of the through hole 560 between the bottom surface 23A and the top surface 24E and between the bottom edge 560B and the bottom surface 25D are not increased, and the conductive layers 21 to 25 do not experience unexpected effects during the manufacturing process.

Thus, according to the fifth embodiment, it becomes possible to provide the printed wiring board 500 which has highly-enhanced transmission characteristics of the high speed signals compared with the conventional printed wiring board manufactured by the conventional method.

Since the plate resist part 550A has enough thickness for isolation, it becomes possible to insulate the vias 540A and 540B effectively.

Although, in the first to fifth embodiments as described above, the holes 70, 470A, 470B and 570 are formed by laser machining, the holes 70, 470A, 470B and 570 may be formed by drilling.

So far, the preferred embodiments and modification of the a printed wiring board, a printed circuit board unit, an electronic apparatus and a method for manufacturing the printed wiring board are described. However, the invention is not limited to those specifically described embodiments and the modification thereof, and various modifications and alteration may be made within the scope of the inventions described in the claims.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of superiority or inferiority of the invention.

Although the embodiments of the present invention have been described in detail, it should be understood that the various changes, substitutions, and alterations could be made hereto without departing from the spirit and scope of the invention.

## Claims

1. A printed wiring board comprising:
insulating layers;
conductive layers stacked with the insulating layers alternately;
a through hole penetrating the insulating layers and the conductive layers;
a first plate resist part formed on a first portion of an inner wall of the through hole, the first portion being located from one end of the through hole to one of the conductive layers stacked between one pair of the insulating layers; and
a plated part formed on a second portion of the inner wall of the through hole other than the first portion.

2. The printed wiring board as claimed in claim 1, wherein an inner diameter of the first portion of the inner wall of the through hole is equal to an inner diameter of the second portion of the inner wall of the through hole.

3. The printed wiring board as claimed in claim 1, wherein an inner diameter of the first portion of the inner wall of the through hole is larger than an inner diameter of the second portion of the inner wall of the through hole.

4. The printed wiring board as claimed in any one of claims 1 to 3, further comprising:
a second plate resist part formed on a third portion of the inner wall of the through hole, the third portion being located from the other end of the through hole to another one of the conductive layers stacked between another pair of the insulating layers, wherein
the plated part is formed on the second portion of the inner wall of the through hole other than the first portion and the third portion.

5. A printed wiring board comprising:
insulating layers including a prepreg layer;
conductive layers stacked with the insulating layers alternately;
a through hole penetrating the insulating layers and the conductive layers;
a plate resist part formed on a first portion of an inner wall of the through hole, the first portion being formed in the prepreg layer and located between a pair of the conductive layers; and
a plated part formed on a second portion of the inner wall of the through hole other than the first portion of the inner wall of the through hole.

6. A printed circuit board unit comprising:
the printed wiring board as claimed in any one of claims 1 to 5; and
an electronic device mounted on the printed wiring board.

7. An electronic apparatus comprising:
the printed wiring board as claimed in claim 1; and
an electronic device mounted on the printed wiring board.

8. A method for manufacturing a printed wiring board, the method comprising:
stacking conductive layers and insulating layers alternately;
forming a through hole penetrating the conductive layers and insulating layers;
forming a plate resist part on a first portion of an inner wall of the through hole, the first portion being located from one end of the through hole to one of the conductive layers stacked between one pair of the insulating layers; and
forming a plated part on a second portion of the inner wall of the through hole other than the first portion.

9. The method for manufacturing the printed wiring board as claimed in claim 8, the method further comprising:
forming a hole from a surface of the stacked conductive layers and insulating layers to one of the conductive layers stacked between one pair of the insulating layers before forming the through hole, and
supplying a plate resist into the hole, wherein
an inner diameter of the hole is larger than an inner diameter of the through hole, and wherein
a plate resist part is formed by forming the through hole which penetrates the plate resist supplied in the hole.

10. A method for manufacturing a printed wiring board, the method comprising:
forming a first through hole in a prepreg layer;
supplying a plate resist into the first through hole;
stacking conductive layers and insulated layers alternately, the insulated layers including the prepreg layer;
forming a second through hole penetrating the stacked conductive layers and insulated layers, the second through hole penetrating the plate resist; and
forming a plated part on a portion of an inner wall of the second through hole other than the plate resists.
